(19) Europäisches Patentamt / European Patent Office / Office européen des brevets

(11) **EP 4 510 405 B1**

(12) **EUROPEAN PATENT SPECIFICATION**

(45) Date of publication and mention
of the grant of the patent:
**17.06.2026 Bulletin 2026/25**

(21) Application number: **23866688.7**

(22) Date of filing: **07.12.2023**

(51) International Patent Classification (IPC):
$H02J\ 3/00^{(2026.01)}$    $H02J\ 13/00^{(2026.01)}$
$G06F\ 30/20^{(2020.01)}$    $G06F\ 17/00^{(2019.01)}$

(52) Cooperative Patent Classification (CPC):
**G06F 30/20; H02J 3/0014; H02J 3/00142;
H02J 13/12;** H02J 2103/30

(86) International application number:
**PCT/CN2023/137027**

(87) International publication number:
**WO 2025/000914 (02.01.2025 Gazette 2025/01)**

(54) **VOLTAGE STABILITY ANALYSIS METHOD AND SYSTEM BASED ON MULTI-SWING CHARACTERISTICS OF VOLTAGE DISTURBANCE CURVE, ELECTRONIC DEVICE, STORAGE MEDIUM, AND COMPUTER PROGRAM PRODUCT**

VERFAHREN UND SYSTEM ZUR SPANNUNGSSTABILITÄTSANALYSE AUF BASIS VON MEHRFACHSCHWINGUNGSEIGENSCHAFTEN EINER SPANNUNGSSTÖRUNGSKURVE, ELEKTRONISCHE VORRICHTUNG, SPEICHERMEDIUM UND COMPUTERPROGRAMMPRODUKT

PROCÉDÉ ET SYSTÈME D'ANALYSE DE STABILITÉ DE TENSION BASÉS SUR DES CARACTÉRISTIQUES MULTI-OSCILLATION D'UNE COURBE DE PERTURBATION DE TENSION, DISPOSITIF ÉLECTRONIQUE, SUPPORT DE STOCKAGE ET PRODUIT-PROGRAMME D'ORDINATEUR

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **30.06.2023 CN 202310787061**

(43) Date of publication of application:
**19.02.2025 Bulletin 2025/08**

(73) Proprietor: **China Electric Power Research Institute
Beijing 100192 (CN)**

(72) Inventors:
- **WEI, Yawei
  Beijing 100192 (CN)**
- **LYU, Ying
  Beijing 100192 (CN)**
- **LU, Guangming
  Beijing 100192 (CN)**
- **YU, Zhihong
  Beijing 100192 (CN)**
- **DAI, Hongyang
  Beijing 100192 (CN)**
- **ZHANG, Lulu
  Beijing 100192 (CN)**
- **WANG, Zigan
  Beijing 100192 (CN)**
- **SHI, Chen
  Beijing 100192 (CN)**
- **WANG, Jiecong
  Beijing 100192 (CN)**
- **WANG, Bing
  Beijing 100192 (CN)**
- **XIE, Mei
  Beijing 100192 (CN)**
- **LI, Yalou
  Beijing 100192 (CN)**
- **TIAN, Fang
  Beijing 100192 (CN)**
- **JIA, Haibo
  Beijing 100192 (CN)**

- **MA, Jing**
  **Beijing 100192 (CN)**
- **LU, Jun**
  **Beijing 100192 (CN)**
- **MIAO, Chunshuai**
  **Beijing 100192 (CN)**
- **CAI, Shunyou**
  **Beijing 100192 (CN)**
- **SONG, Yuanming**
  **Beijing 100192 (CN)**

(74) Representative: **White, Andrew John et al**
  **Mathys & Squire**
  **The Shard**
  **32 London Bridge Street**
  **London SE1 9SG (GB)**

(56) References cited:
**CN-A- 109 101 890**      **CN-A- 113 506 186**
**CN-A- 113 949 065**      **CN-A- 113 949 065**
**CN-A- 113 949 069**      **CN-A- 113 949 069**
**CN-A- 116 505 526**      **US-A1- 2016 124 031**
**US-A1- 2020 300 907**

**Description**

TECHNICAL FIELD

The disclosure relates to, but is not limited to, a technical field of power grid stability analysis, and in particular to a method and system for analyzing voltage stability based on a multi-swing characteristic of a voltage disturbance curve, an electronic device, a storage medium, and a computer program product.

BACKGROUND

Methods for analyzing dynamic voltage stability provided in the related art have disadvantages of complex presetting required for analysis and judgment, long simulation time, complex calculation, low accuracy, etc.
Documents CN 113 949 065 A (CHINA ELECTRIC POWER RES INST) 18 January 2022 (2022-01-18) and CN 113 949 069 A (CHINA ELECTRIC POWER RES INST) 18 January 2022 (2022-01-18) are examples of prior art.

SUMMARY

Embodiments of the present disclosure provide a method and system for analyzing voltage stability based on a multi-swing characteristic of a voltage disturbance curve, an electronic device, a storage medium, and a computer program product.
Embodiments of the present disclosure provide a method for analyzing voltage stability based on a multi-swing characteristic of a voltage disturbance curve. The method includes the following operations.
A main server acquires a voltage disturbance curve of at least one node; and for each voltage disturbance curve, analyzes the voltage disturbance curve based on a multi-swing characteristic, to determine analysis time and a number of processing layers for curve wavelet package decomposition corresponding to the voltage disturbance curve.
The main server establishes an analysis task for each node, and distributes the analysis task to at least one sub-server according to a preset distribution strategy.
For one of the at least one sub-server, based on analysis time and a number of processing layers for curve wavelet package decomposition corresponding to a voltage disturbance curve of a node corresponding to an analysis task that is received, a wavelet package analysis is performed on the voltage disturbance curve, to acquire a wavelet decomposition coefficient of each layer corresponding to the voltage disturbance curve of the node corresponding to the analysis task.
For the one of the at least one sub-server, according to the wavelet decomposition coefficient of each layer corresponding to the voltage disturbance curve of the node corresponding to the analysis task, a characteristic value of each layer is determined.
For the one of the at least one sub-server, according to the characteristic value and a characteristic threshold of each layer corresponding to the voltage disturbance curve of the node corresponding to the analysis task, a voltage stability analysis result of the node corresponding to the analysis task is determined.
In some implementations, a type of the node includes at least one of: a load node, a direct-current (DC) station node, a capacitance node, a generator node, a phase modulator node, or a renewable energy station node.
In some implementations, the operation of analyzing the voltage disturbance curve based on the multi-swing characteristic, to determine the analysis time and the number of processing layers for curve wavelet package decomposition corresponding to the voltage disturbance curve further includes the following operations. For each voltage disturbance curve, a wavelet package analysis is performed on the voltage disturbance curve, to acquire a vibration intensity of the voltage disturbance curve. According to the vibration intensity, the analysis time and the number of processing layers for curve wavelet package decomposition for the voltage disturbance curve are determined. Here, for the voltage disturbance curve, in response to that the vibration intensity is within a first preset vibration intensity range, the analysis time corresponding to the voltage disturbance curve is determined as preset analysis time, and the number of processing layers for curve wavelet package decomposition corresponding to the voltage disturbance curve is determined as a first preset layer number. In response to that the vibration intensity is within a second preset vibration intensity range, the analysis time corresponding to the voltage disturbance curve is determined according to vibration time of the voltage disturbance curve, and the number of processing layers for curve wavelet package decomposition corresponding to the voltage disturbance curve is determined as a second preset layer number.
In some implementations, the wavelet decomposition coefficient of each layer corresponding to the voltage disturbance curve of the node corresponding to the analysis task is determined by:

$$d_{hn} = \sum_{l=0}^{2^n-1} h_{n-2l} d_{h(2l)} + \sum_{l=0}^{2^n-1} g_{n-2l} d_{g(2l)}$$

$$d_{gn} = \sum_{l=0}^{2^n-1} h_{n-(2l+1)} d_{h(2l)} + \sum_{l=0}^{2^n-1} g_{n-(2l+1)} d_{g(2l+1)}$$

here, $d_{hn}$ is a high-frequency wavelet decomposition coefficient of a $n^{th}$ layer; $d_{gn}$ is a low-frequency wavelet decomposition coefficient of the $n^{th}$ layer; $l$ is a number of wavelet subspaces decomposed to the $n^{th}$ layer; $h_{n-2l}$, $h_{n-(2l+1)}$, $g_{n-2l}$ and $g_{n-(2l+1)}$ are general functions of real coefficient filters for wavelet analysis; $d_{h(2l)}$ is a high-frequency wavelet decomposition subspace coefficient decomposed to the $n^{th}$ layer, indicating that a high-frequency wavelet coefficient of the $n^{th}$ layer contains a combination of $2l$ subspace wavelet high-frequency coefficients; $d_{g(2l)}$ is a low-frequency wavelet decomposition subspace coefficient decomposed to the $n^{th}$ layer, indicating that the high-frequency wavelet coefficient of the $n^{th}$ layer contains a combination of $2l$ subspace wavelet low-frequency coefficients; and $d_{g(2l+1)}$ is a low-frequency wavelet decomposition subspace coefficient decomposed to the $n^{th}$ layer, indicating that a combination of $2l+1$ subspace wavelet low-frequency coefficients is further contained in the low-frequency wavelet decomposition coefficient $d_{gn}$ of the $n^{th}$ layer.

In some implementations, the characteristic value of each layer is determined, according to the wavelet decomposition coefficient of each layer corresponding to the voltage disturbance curve of the node corresponding to the analysis task, by:

$$E_{ntotal} = E_{hn} + E_{gn}$$

$$E_{hn} = \sqrt{2} \sum_{k=0}^{n} d_{hn} \mu_{2n}(2t-k) f_{hn}(t)$$

$$E_{gn} = \sqrt{2} \sum_{k=0}^{n} d_{gn} \mu_{2n}(2t-k) f_{gn}(t)$$

$$\mu_{2n}(2t-k) = \frac{2\xi^2}{f_p^3 \sqrt{\pi}} e^{\left(-\frac{\xi^2}{f_p^2}\right)} e^{-j2\pi\xi(2t-k)}$$

here, $E_{ntotal}$ is a characteristic value of a $n^{th}$ layer; $E_{hn}$ and $E_{gn}$ are characteristic values of high-frequency and low-frequency wavelets of the $n^{th}$ layer respectively; $d_{hn}$ is a high-frequency wavelet decomposition coefficient of the $n^{th}$ layer; $d_{gn}$ is a low-frequency wavelet decomposition coefficient of the $n^{th}$ layer; $f(t)$ is a function formed by voltage disturbance curve data to be analyzed, and $t$ is analysis time; $f_{hn}(t)$ is a high-frequency decomposition function of the $n^{th}$ layer at a moment $t$, and $f_{gn}(t)$ is a low-frequency decomposition function of the $n^{th}$ layer at the moment $t$; $\mu_{2n}(2t - k)$ is a wavelet package generating function determined by an orthogonal scaling function, $t$ is the analysis time, $k$ is a number of wavelet subspaces, and $f_p$ is a fluctuation frequency of the disturbance curve; $\xi$ is a truncation error coefficient of wavelet decomposition; and $j$ represents an imaginary part.

In some implementations, the method further includes the following operation.

The characteristic threshold of each layer is determined by:

$$Th_n = \| \mu_n \|^2 + \tau^T \times J_4^{-1}$$

here, $Th_n$ is a characteristic threshold corresponding to a $n^{th}$ layer; $\mu_n$ is a bifurcation control parameter corresponding to the n$^{th}$ layer; $\tau^T$ is a transpose of a Lagrange multiplier $\tau$; and $J_4^{-1}$ is an inverse matrix of a characteristic value matrix $J_4$ of differential algebraic equations (DAE) for a high-proportioned renewable energy integrated power system.

In some implementations, the operation of determining, according to the characteristic value and the characteristic threshold of each layer corresponding to the voltage disturbance curve of the node corresponding to the analysis task, the voltage stability analysis result of the node corresponding to the analysis task further includes the following operations. For a characteristic value of a layer corresponding to the voltage disturbance curve of the node corresponding to the analysis task, the voltage stability analysis result of the node corresponding to the analysis task is determined as a voltage instability node, in response to that the characteristic value of the layer is greater than or equal to a characteristic threshold of a current layer. The voltage stability analysis result of the node corresponding to the analysis task is determined as a voltage stability node, in response to that the characteristic value of the layer is lower than the characteristic threshold of the current layer.

Embodiments of the present disclosure provide a system for analyzing voltage stability based on a multi-swing characteristic of a voltage disturbance curve. The system includes a voltage disturbance curve analysis section, a task distribution section, a wavelet decomposition coefficient determination section, a characteristic value determination section, and a stability analysis section.

The voltage disturbance curve analysis section is configured to acquire, through a main server, a voltage disturbance curve of at least one node; and for each voltage disturbance curve, analyze, through the main server, the voltage disturbance curve based on a multi-swing characteristic, to determine analysis time and the number of processing layers for curve wavelet package decomposition corresponding to the voltage disturbance curve.

The task distribution section is configured to establish, through the main server, an analysis task for each node, and distribute, through the main server, the analysis task to at least one sub-server according to a preset distribution strategy.

The wavelet decomposition coefficient determination section is configured to perform, for one of the at least one sub-server, based on analysis time and a number of processing layers for curve wavelet package decomposition corresponding to a voltage disturbance curve of a node corresponding to an analysis task that is received, a wavelet package analysis on the voltage disturbance curve, to acquire a wavelet decomposition coefficient of each layer corresponding to the voltage disturbance curve of the node corresponding to the analysis task.

The characteristic value determination section is configured to determine, for the one of the at least one sub-server, according to the wavelet decomposition coefficient of each layer corresponding to the voltage disturbance curve of the node corresponding to the analysis task, a characteristic value of each layer.

The stability analysis section is configured to determine, for the one of the at least one sub-server, according to the characteristic value and a characteristic threshold of each layer corresponding to the voltage disturbance curve of the node corresponding to the analysis task, a voltage stability analysis result of the node corresponding to the analysis task.

In some implementations, a type of the node includes at least one of: a load node, a direct-current (DC) station node, a capacitance node, a generator node, a phase modulator node, or a renewable energy station node.

In some implementations, the voltage disturbance curve analysis section is further configured to: for each voltage disturbance curve, perform a wavelet package analysis on the multi-swing characteristic of the voltage disturbance curve, to acquire a vibration intensity of the voltage disturbance curve; and determine, according to the vibration intensity, the analysis time and the number of processing layers for curve wavelet package decomposition for the voltage disturbance curve. Here, for the voltage disturbance curve, in response to that the vibration intensity is within a first preset vibration intensity range, the analysis time corresponding to the voltage disturbance curve is determined as preset analysis time, and the number of processing layers for curve wavelet package decomposition corresponding to the voltage disturbance curve is determined as a first preset layer number. **In** response to that the vibration intensity is within a second preset vibration intensity range, the analysis time corresponding to the voltage disturbance curve is determined according to vibration time of the voltage disturbance curve, and the number of processing layers for curve wavelet package decomposition corresponding to the voltage disturbance curve is determined as a second preset layer number.

In some implementations, the wavelet decomposition coefficient determination section is further configured to determine the wavelet decomposition coefficient of each layer corresponding to the voltage disturbance curve of the node corresponding to the analysis task by:

$$d_{hn} = \sum_{l=0}^{2^n-1} h_{n-2l} d_{h(2l)} + \sum_{l=0}^{2^n-1} g_{n-2l} d_{g(2l)} \quad,$$

$$d_{gn} = \sum_{l=0}^{2^n-1} h_{n-(2l+1)} d_{h(2l)} + \sum_{l=0}^{2^n-1} g_{n-(2l+1)} d_{g(2l+1)}$$,

here, $d_{hn}$ is a high-frequency wavelet decomposition coefficient of a $n^{th}$ layer; $d_{gn}$ is a low-frequency wavelet decomposition coefficient of the $n^{th}$ layer; $l$ is a number of wavelet subspaces decomposed to the $n^{th}$ layer; $h_{n-2l}$, $h_{n-(2l+1)}$, $g_{n-2l}$ and $g_{n-(2l+1)}$ are general functions of real coefficient filters for wavelet analysis; $d_{h(2l)}$ is a high-frequency wavelet decomposition subspace coefficient decomposed to the $n^{th}$ layer, indicating that a high-frequency wavelet coefficient of the $n^{th}$ layer contains a combination of $2l$ subspace wavelet high-frequency coefficients; $d_{g(2l)}$ is a low-frequency wavelet decomposition subspace coefficient decomposed to the $n^{th}$ layer, indicating that the high-frequency wavelet coefficient of the $n^{th}$ layer contains a combination of $2l$ subspace wavelet low-frequency coefficients; and $d_{g(2l+1)}$ is a low-frequency wavelet decomposition subspace coefficient decomposed to the $n^{th}$ layer, indicating that a combination of $2l+1$ subspace wavelet low-frequency coefficients is further contained in the low-frequency wavelet decomposition coefficient $d_{gn}$ of the $n^{th}$ layer.

In some implementations, the characteristic value determination section is further configured to determine, according to the wavelet decomposition coefficient of each layer corresponding to the voltage disturbance curve of the node corresponding to the analysis task, the characteristic value of each layer by:

$$E_{ntotal} = E_{hn} + E_{gn}.$$

$$E_{hn} = \sqrt{2} \sum_{k=0}^{n} d_{hn} \mu_{2n}(2t-k) f_{hn}(t)$$,

$$E_{gn} = \sqrt{2} \sum_{k=0}^{n} d_{gn} \mu_{2n}(2t-k) f_{gn}(t)$$,

$$\mu_{2n}(2t-k) = \frac{2\xi^2}{f_p^3 \sqrt{\pi}} e^{(-\frac{\xi^2}{f_p^2})} e^{-j2\pi\xi(2t-k)}$$,

here, $E_{ntotal}$ is a characteristic value of a $n^{th}$ layer; $E_{hn}$ and $E_{gn}$ are characteristic values of high-frequency and low-frequency wavelets of the $n^{th}$ layer respectively; $d_{hn}$ is a high-frequency wavelet decomposition coefficient of the $n^{th}$ layer; $d_{gn}$ is a low-frequency wavelet decomposition coefficient of the $n^{th}$ layer; $f(t)$ is a function formed by voltage disturbance curve data to be analyzed, and $t$ is analysis time; $f_{hn}(t)$ is a high-frequency decomposition function of the $n^{th}$ layer at a moment $t$, and $f_{gn}(t)$ is a low-frequency decomposition function of the $n^{th}$ layer at the moment $t$; $\mu_{2n}(2t-k)$ is a wavelet package generating function determined by an orthogonal scaling function, $t$ is the analysis time, $k$ is a number of wavelet subspaces, and $f_p$ is a fluctuation frequency of the disturbance curve; $\xi$ is a truncation error coefficient of wavelet decomposition; and $j$ represents an imaginary part.

In some implementations, the system further includes a characteristic threshold determination section, and the characteristic threshold determination section is configured to determine the characteristic threshold of each layer by:

$$Th_n = \| \mu_n \|^2 + \tau^T \times J_4^{-1}$$,

here, $Th_n$ is a characteristic threshold corresponding to a $n^{th}$ layer; $\mu_n$ is a bifurcation control parameter corresponding to the $n^{th}$ layer; $\tau^T$ is a transpose of a Lagrange multiplier $\tau$; and $J_4^{-1}$ is an inverse matrix of a characteristic value matrix $J_4$ of differential algebraic equations (DAE) for a high-proportioned renewable energy integrated power system.

In some implementations, the stability analysis section is further configured to:

for a characteristic value of a layer corresponding to the voltage disturbance curve of the node corresponding to the analysis task, determine the voltage stability analysis result of the node corresponding to the analysis task as a voltage instability node, in response to that the characteristic value of the layer is greater than or equal to a characteristic threshold of a current layer; and determine the voltage stability analysis result of the node corresponding to the analysis task as a voltage stability node, in response to that the characteristic value of the layer is lower than the characteristic threshold of the current layer.

Embodiments of the present disclosure provide a computer-readable storage medium having stored thereon a computer program, and when executed by a processor, the computer program enables the processor to implement any one of operations of a method for analyzing voltage stability based on a multi-swing characteristic of a voltage disturbance curve.

Embodiments of the present disclosure provide an electronic device, and the electronic device includes:

the computer-readable storage medium mentioned above, and
one or more processors configured to execute a program in the computer-readable storage medium.

Embodiments of the present disclosure provide a computer program product, and the computer program product includes a computer program or instruction. When running on an electronic device, the computer program or instruction enables the electronic device to implement any one of operations of a method for analyzing voltage stability based on a multi-swing characteristic of a voltage disturbance curve.

In the embodiments of the present disclosure, the main server acquires the voltage disturbance curve of at least one node; and for each voltage disturbance curve, the main server analyzes the voltage disturbance curve based on the multi-swing characteristic, to determine the analysis time and the number of processing layers for curve wavelet package decomposition corresponding to the voltage disturbance curve. The main server establishes the analysis task for each node, and distributes the analysis task to at least one sub-server according to a preset distribution strategy. For one of the at least one sub-server, based on analysis time and the number of processing layers for curve wavelet package decomposition corresponding to the voltage disturbance curve of the node corresponding to the analysis task that is received, the wavelet package analysis is performed on the voltage disturbance curve, to acquire the wavelet decomposition coefficient of each layer corresponding to the voltage disturbance curve of the node corresponding to the analysis task. For the one of the at least one sub-server, according to the wavelet decomposition coefficient of each layer corresponding to the voltage disturbance curve of the node corresponding to the analysis task, the characteristic value of each layer is determined. Additionally, for the one of the at least one sub-server, according to the characteristic value and the characteristic threshold of each layer corresponding to the voltage disturbance curve of the node corresponding to the analysis task, the voltage stability analysis result of the node corresponding to the analysis task is determined. The present disclosure analyzes, based on a parallel calculation manner, the voltage disturbance curve of the power system node under a fault by using the wavelet package decomposition method, and further performs stability analysis according to the acquired characteristic value. Thus, a fast, effective and reliable voltage stability judgment can be realized.

It should be understood that the general description above and the following detailed description are exemplary and explanatory, which are not limits to the present disclosure.

BRIEF DESCRIPTION OF THE DRAWINGS

In order to provide a clearer explanation for technical solutions of the embodiments of the present disclosure, the drawings required to be used in the embodiments of the present disclosure or in the background technology are described below.

The drawings, which are incorporated to the description and constitute a part of the description, illustrate embodiments in accordance with the present disclosure and, together with the description, serve to explain the technical solutions of the present disclosure.

FIG. 1 is a schematic flowchart of a method 100 for analyzing voltage stability based on a multi-swing characteristic of a voltage disturbance curve according to an embodiment of the present disclosure.
FIG. 2 is a structural diagram of a system 200 for analyzing voltage stability based on a multi-swing characteristic of a voltage disturbance curve according to an embodiment of the present disclosure.

DETAILED DESCRIPTION

Exemplary implementations of the present disclosure are described with reference to the drawings. However, the present disclosure may be implemented in many different forms, which is not limited to the embodiments described herein. Such embodiments are provided to fully and thoroughly disclose the present disclosure, and further fully convey the scope of the present disclosure to those skilled in the art. Terms for representing the exemplary implementations in the drawings are not limitations of the present disclosure. In the drawings, same units/components are marked with same reference symbols.

Unless otherwise specified, terms (including technical terms) used herein have the same meaning as generally understood by those skilled in the art to which the present disclosure belongs. Furthermore, it is understood that terms defined in dictionaries used commonly should be understood as meanings consistent with the context of relevant fields thereof, rather than being understood as idealized or overly formal meanings.

With the gradual penetration of a renewable energy strategy and dual-carbon policy, renewable energy power generation methods, such as wind power and photovoltaic power, have achieved further rapid development. In order to ensure a power integration level of renewable energy power generation, power grids in various regions have carried out corresponding works on replacing traditional-energy power generation with the renewable energy power generation, which causes retirement of large-scale conventional thermal power generation units, and also causes fundamental changes in a power grid arrangement. As such, insufficient capability for adjusting a dynamic voltage of power systems is caused, which leads to new challenges to security and stability state of potential online operations. Such challenges are mainly reflected in that, due to randomness and fluctuation of outputs of the renewable energy such as wind and light as well as a different voltage adjustment characteristic of the renewable energy compared to the conventional power generation units, voltage adjustment and anti-disturbance capabilities of the systems are worsened to a certain extent, and a complexity of judging the dynamic voltage stability of the power systems is significantly increased. Under the background of profound changes in output components and power integration modes of the whole power grid currently, voltage characteristics of the power grid have also undergone fundamental changes, i.e., a problem of feature extraction and analysis for dynamic voltage security and stability is evolved from a problem of analysis for quasi-static voltage balance.

In the related art, a Lyapunov energy function method is adopted. Firstly, a correlation model between transient voltage stability analysis of power grid mechanism and transient voltage stability characteristics driven by data is constructed. On such basis, Shapelet transform method in time-series classification learning is used for learning key stability characteristics in time-series response trajectory. As such, a transient voltage stability evaluation model driven by time-series response data is established, to realize transient voltage stability evaluation. Disadvantages of such method are as follows: key time-series characteristics of transient voltage stability/instability still need to be compared and constructed by an offline Lyapunov energy function model. Such method has high specificity, needs complex setting in early stage and complex learning process, takes a long time for manual setting, has high limitation on a specific power grid for key characteristics, and further has a weak generalization ability.

Generally speaking, the existing methods for analyzing the dynamic voltage stability need complex presetting required for analysis and judgment, long simulation time and complex calculation. Due to a lack of a fast, accurate and simple method for evaluating the dynamic voltage stability, dispatchers often make emergency decisions in actual analysis according to scheduling experiences. The accuracy of such method, adaptability and feasibility with the current operation mode of the power grids may be biased. The workload of relying on manual analysis successively is relatively large, which easily causes the dispatchers of the power grids to be distracted and lose focus during their duty. Considering a high-proportioned renewable energy integrated power system, the demand for judging the dynamic voltage stability rapidly is increased. It is urgent to study a method for analyzing dynamic voltage stability.

Therefore, it is required for a method for analyzing voltage stability based on a multi-swing characteristic of a voltage disturbance curve.

In the present disclosure, for any voltage disturbance curve, a multi-swing characteristic refers to a swing curve characteristic formed by a dynamic fluctuation recovery process in which a voltage recovers from a lowest point of a fault drop to a stable voltage value after the fault ends. A multi-swing characteristic of the voltage disturbance curve that can recover to a stable voltage value before the fault is referred to as a dynamic stability multi-swing characteristic. A multi-swing characteristic of the voltage disturbance curve that cannot recover to the stable voltage value before the fault is referred to as a dynamic instability multi-swing characteristic.

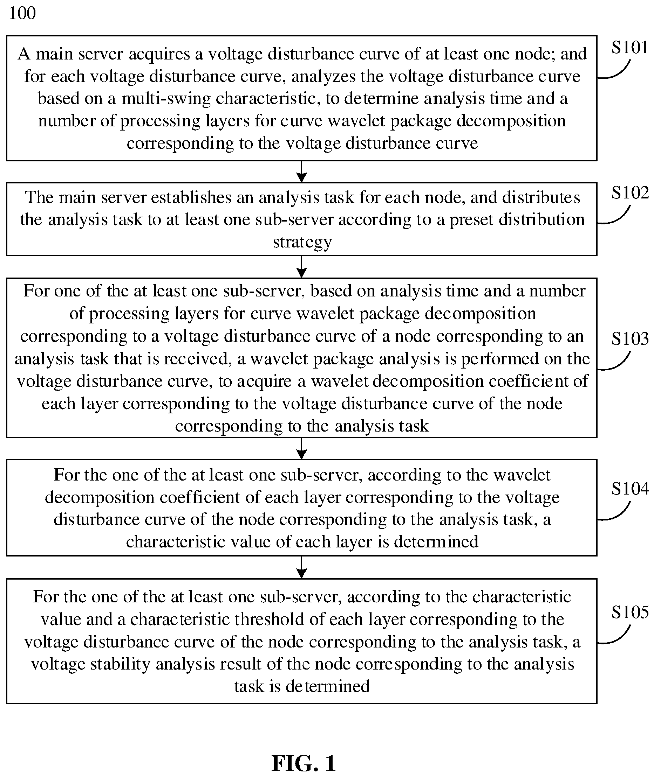

FIG. 1 is a schematic flowchart of a method 100 for analyzing voltage stability based on a multi-swing characteristic of a voltage disturbance curve according to an embodiment of the present disclosure. As shown in FIG. 1, the method for analyzing voltage stability based on the multi-swing characteristic of the voltage disturbance curve provided by the embodiments of the present disclosure analyzes, based on a parallel calculation manner, a voltage disturbance curve of a power system node under a fault by using a wavelet package decomposition method; and further performs stability analysis according to the acquired characteristic value. Thus, a fast, effective and reliable voltage stability judgment can be realized. The method 100 for analyzing the voltage stability based on the multi-swing characteristic of the voltage disturbance curve provided by the implementations of the present disclosure includes operations S101 to S105.

At S101, a main server acquires a voltage disturbance curve of at least one node; and for each voltage disturbance curve, analyzes the voltage disturbance curve based on a multi-swing characteristic, to determine analysis time and the number of processing layers for curve wavelet package decomposition corresponding to the voltage disturbance curve.

In some implementations, a type of the node includes at least one of: a load node, a direct-current (DC) station node, a capacitance node, a generator node, a phase modulator node, or a renewable energy station node.

In some implementations, the operation of analyzing the voltage disturbance curve based on the multi-swing characteristic, to determine the analysis time and the number of processing layers for curve wavelet package decomposition corresponding to the voltage disturbance curve, further includes the following operations.

For each voltage disturbance curve, a wavelet package analysis is performed on the voltage disturbance curve, to acquire a vibration intensity of the voltage disturbance curve.

According to the vibration intensity, the analysis time and the number of processing layers for curve wavelet package decomposition for the voltage disturbance curve are determined.

Here, for the voltage disturbance curve, in response to that the vibration intensity is within a first preset vibration intensity range, the analysis time corresponding to the voltage disturbance curve is determined as preset analysis time, and the number of processing layers for curve wavelet package decomposition corresponding to the voltage disturbance curve is determined as a first preset layer number. In response to that the vibration intensity is within a second preset vibration intensity range, the analysis time corresponding to the voltage disturbance curve is determined according to vibration time of the voltage disturbance curve, and the number of processing layers for curve wavelet package decomposition corresponding to the voltage disturbance curve is determined as a second preset layer number.

At S102, the main server establishes an analysis task for each node, and distributes the analysis task to at least one sub-server according to a preset distribution strategy.

In the present disclosure, the main server acquires a global dynamic voltage stability analysis task of a power system, and further acquires the voltage disturbance curve of the at least one node. Here, the type of the node includes at least one of: the load node, the DC station node, the capacitance node, the generator node, the phase modulator node, or the renewable energy station node. For each voltage disturbance curve, the voltage disturbance curve is analyzed based on the multi-swing characteristic, to determine the analysis time and the number of processing layers for the curve wavelet package decomposition corresponding to the voltage disturbance curve. A correlation relationship among the voltage disturbance curve, the analysis time and the number of processing layers for curve wavelet package decomposition is established. Then, the analysis task for each node is established, and according to the preset distribution strategy, the analysis task is distributed to the at least one sub-server based on the correlation relationship, such that all sub-servers may execute the analysis task in parallel. Thus, the analysis efficiency can be improved.

In the present disclosure, for a voltage disturbance curve of any node after the fault, the main server performs the wavelet package analysis on the voltage disturbance curve, to acquire a vibration intensity of the voltage disturbance curve. Then, the analysis time and the number of layers for wavelet package decomposition are determined according to the vibration intensity. Here, for any voltage disturbance curve, in response to that the vibration intensity is within the first preset vibration intensity range, the analysis time corresponding to the voltage disturbance curve is determined as the preset analysis time, and the number of processing layers for curve wavelet package decomposition corresponding to the voltage disturbance curve is determined as the first preset layer number. In response to that the vibration intensity is within the second preset vibration intensity range, the analysis time corresponding to the voltage disturbance curve is determined according to the vibration time of the voltage disturbance curve, and the number of processing layers for curve wavelet package decomposition corresponding to the voltage disturbance curve is determined as the second preset layer number.

In the present disclosure, each of the first preset vibration intensity range, the second preset vibration intensity range, the preset analysis time, the first preset layer number and the second preset layer number may be set according to requirements. Here, the first preset vibration intensity range is much lower than the second preset vibration intensity range. The vibration intensity of the voltage disturbance curve is generally polarized and not in a middle value, such that the voltage disturbance curve may be classified based on the first preset vibration intensity range and the second vibration intensity range. The first preset layer number is lower than the second preset layer number. For example, the first preset layer number may be set to be 3, and the second preset layer number may be set to be 10.

Furthermore, in the present disclosure, the main server may further acquire a resource occupation status and a task execution status of each sub-server, to forward the analysis task according to the resource occupation status and the task execution status. Thus, the processing efficiency can be more efficient.

At S103, for one of the at least one sub-server, based on analysis time and the number of processing layers for curve wavelet package decomposition corresponding to a voltage disturbance curve of a node corresponding to an analysis task that is received, a wavelet package analysis is performed on the voltage disturbance curve, to acquire a wavelet decomposition coefficient of each layer corresponding to the voltage disturbance curve of the node corresponding to the analysis task.

In some implementations, the wavelet decomposition coefficient of each layer corresponding to the voltage disturbance curve of the node corresponding to the analysis task is determined by:

$$d_{hn} = \sum_{l=0}^{2^n-1} h_{n-2l} d_{h(2l)} + \sum_{l=0}^{2^n-1} g_{n-2l} d_{g(2l)} ,$$

$$d_{gn} = \sum_{l=0}^{2^n-1} h_{n-(2l+1)} d_{h(2l)} + \sum_{l=0}^{2^n-1} g_{n-(2l+1)} d_{g(2l+1)} ,$$

here, $d_{hn}$ is a high-frequency wavelet decomposition coefficient of a $n^{th}$ layer; $d_{gn}$ is a low-frequency wavelet decomposition coefficient of the $n^{th}$ layer; $l$ is a number of wavelet subspaces decomposed to the $n^{th}$ layer; $h_{n-2l}$, $h_{n-(2l+1)}$, $g_{n-2l}$ and $g_{n-(2l+1)}$ are general functions of real coefficient filters for wavelet analysis; $d_{h(2l)}$ is a high-frequency wavelet decomposition subspace coefficient decomposed to the $n^{th}$ layer, indicating that a high-frequency wavelet coefficient of the $n^{th}$ layer contains a combination of $2l$ subspace wavelet high-frequency coefficients; $d_{g(2l)}$ is a low-frequency wavelet decomposition subspace coefficient decomposed to the $n^{th}$ layer, indicating that the high-frequency wavelet coefficient of the $n^{th}$ layer contains a combination of $2l$ subspace wavelet low-frequency coefficients; and $d_{g(2l+1)}$ is a low-frequency wavelet decomposition subspace coefficient decomposed to the $n^{th}$ layer, indicating that a combination of $2l+1$ subspace wavelet low-frequency coefficients is further contained in the low-frequency wavelet decomposition coefficient $d_{gn}$ of the $n^{th}$ layer.

In the present disclosure, for one of the at least one sub-server, a wavelet package algorithm (WPA) analysis is performed on the voltage disturbance curve of the node, to acquire the wavelet decomposition coefficient of each layer.

For a selection of a wavelet base for discrete wavelet analysis on a dynamic voltage disturbance recovery curve, adaptive wavelet clusters are used to approximately extract wavelet decomposition coefficients from the high-frequency wavelet decomposition coefficient $d_{hn}$ and the low-frequency wavelet decomposition coefficient $d_{gn}$.

The formulas for calculating the wavelet decomposition coefficients are:

$$\mu_{2n}(t) = \sqrt{2} \sum_{k=0}^{2^n-1} d_{hn} \mu_{2n}(2t - k) ,$$

$$\mu_{2n+1}(t) = \sqrt{2} \sum_{k=0}^{2^n-1} d_{gn} \mu_{2n}(2t - k) ,$$

here, $\mu_{n=0,1,2,3...} = \phi$ is a wavelet package generating function determined by an orthogonal scaling function; and $\{\mu_{n,k}; k = 0,1,2...2^n -1\}$ represents an orthogonal base of a wavelet function with the $n^{th}$ layer.

A following wavelet package generating functions is adopted in the present disclosure:

$$\phi = \frac{2\xi^2}{f_p^3 \sqrt{\pi}} e^{(-\frac{\xi^2}{f_p^2})} e^{-j2\pi\xi t_0} ,$$

here, $f_p$ is a fluctuation frequency of the disturbance curve; and $t_0$ is fluctuation delay time.

Therefore, the wavelet decomposition coefficients are acquired as:

$$d_{hn} = \sum_{l=0}^{2^n-1} h_{n-2l} d_{h(2l)} + \sum_{l=0}^{2^n-1} g_{n-2l} d_{g(2l)} ,$$

$$d_{gn} = \sum_{l=0}^{2^n-1} h_{n-(2l+1)} d_{h(2l)} + \sum_{l=0}^{2^n-1} g_{n-(2l+1)} d_{g(2l+1)} ,$$

here, $d_{hn}$ is the high-frequency wavelet decomposition coefficient of the n$^{th}$ layer; $d_{gn}$ is the low-frequency wavelet decomposition coefficient of the n$^{th}$ layer; $l$ is the number of wavelet subspaces decomposed to the n$^{th}$ layer; $h_{n-2l}$, $h_{n-(2l+1)}$, $g_{n-2l}$ and $g_{n-(2l+1)}$ are the general functions of real coefficient filters for wavelet analysis; $d_{h(2l)}$ is the high-frequency wavelet decomposition subspace coefficient decomposed to the n$^{th}$ layer, indicating that the high-frequency wavelet coefficient of the n$^{th}$ layer contains the combination of $2l$ subspace wavelet high-frequency coefficients; $d_{g(2l)}$ is the low-frequency wavelet decomposition subspace coefficient decomposed to the n$^{th}$ layer, indicating that the high-frequency wavelet coefficient of the n$^{th}$ layer contains the combination of $2l$ subspace wavelet low-frequency coefficients; and $d_{g(2l+1)}$ is the low-frequency wavelet decomposition subspace coefficient decomposed to the n$^{th}$ layer, indicating that the combination of $2l+1$ subspace wavelet low-frequency coefficients is further contained in the low-frequency wavelet decomposition coefficient $d_{gn}$ of the n$^{th}$ layer.

At S104, for the one of the at least one sub-server, according to the wavelet decomposition coefficient of each layer corresponding to the voltage disturbance curve of the node corresponding to the analysis task, a characteristic value of each layer is determined.

In some implementations, the characteristic value of each layer is determined, according to the wavelet decomposition coefficient of each layer corresponding to the voltage disturbance curve of the node corresponding to the analysis task, by:

$$E_{ntotal} = E_{hn} + E_{gn},$$

$$E_{hn} = \sqrt{2} \sum_{k=0}^{n} d_{hn} \mu_{2n}(2t - k) f_{hn}(t),$$

$$E_{gn} = \sqrt{2} \sum_{k=0}^{n} d_{gn} \mu_{2n}(2t - k) f_{gn}(t),$$

$$\mu_{2n}(2t - k) = \frac{2\xi^2}{f_p^3 \sqrt{\pi}} e^{(-\frac{\xi^2}{f_p^2})} e^{-j2\pi\xi(2t-k)},$$

here, $E_{ntotal}$ is a characteristic value of a n$^{th}$ layer; $E_{hn}$ and $E_{gn}$ are characteristic values of high-frequency and low-frequency wavelets of the n$^{th}$ layer respectively; $d_{hn}$ is a high-frequency wavelet decomposition coefficient of the n$^{th}$ layer; $d_{gn}$ is a low-frequency wavelet decomposition coefficient of the n$^{th}$ layer; $f(t)$ is a function formed by voltage disturbance curve data to be analyzed, and $t$ is analysis time; $f_{hn}(t)$ is a high-frequency decomposition function of the n$^{th}$ layer at a moment $t$, and $f_{gn}(t)$ is a low-frequency decomposition function of the n$^{th}$ layer at the moment $t$; $\mu_{2n}(2t - k)$ is a wavelet package generating function determined by an orthogonal scaling function, $t$ is the analysis time, $k$ is the number of wavelet subspaces, and $f_p$ is a fluctuation frequency of the disturbance curve; $\xi$ is a truncation error coefficient of wavelet decomposition; and $j$ represents an imaginary part.

In the present disclosure, the high-frequency characteristic value $E_{hn}$ and the low-frequency characteristic value $E_{gn}$ of the vibration characteristic of the disturbance curve of the n$^{th}$ layer are calculated by the WPA method as the following:

$$E_{hn} = \sqrt{2} \sum_{k=0}^{n} d_{hn} \mu_{2n}(2t - k) f_{hn}(t),$$

$$E_{gn} = \sqrt{2} \sum_{k=0}^{n} d_{gn} \mu_{2n}(2t - k) f_{gn}(t),$$

$$\mu_{2n}(2t-k) = \frac{2\xi^2}{f_p^3 \sqrt{\pi}} e^{\left(-\frac{\xi^2}{f_p^2}\right)} e^{-j2\pi\xi(2t-k)}$$

,

here, $f_{hn}(t)$ is the high-frequency decomposition function of the $n^{th}$ layer at the moment $t$, and $f_{gn}(t)$ is the low-frequency decomposition function of the $n^{th}$ layer at the moment . When n=0, $f_{hn}(t)$ and $f_{gn}(t)$ represent the disturbance curve itself. Additionally, $d_{hn}$ is the high-frequency wavelet decomposition coefficient of the $n^{th}$ layer; $d_{gn}$ is the low-frequency wavelet decomposition coefficient of the $n^{th}$ layer; $f(t)$ is the function formed by the voltage disturbance curve data to be analyzed, and $t$ is the analysis time. $\mu_{2n}(2t - k)$ is the wavelet package generating function determined by the orthogonal scaling function, $t$ is the analysis time, $k$ is the number of wavelet subspaces, and $f_p$ is the fluctuation frequency of the disturbance curve. $\xi$ is the truncation error coefficient of wavelet decomposition, which may be 95%; and $j$ represents the imaginary part.

The characteristic value $E_{ntotal}$ of the vibration of the disturbance curve of the $n^{th}$ layer is: $E_{ntotal} = E_{hn} + E_{gn}$.

Here, $E_{ntotal}$ is the characteristic value of the $n^{th}$ layer; and $E_{hn}$ and $E_{gn}$ are the characteristic values of the high-frequency and low-frequency wavelets of the $n^{th}$ layer respectively.

At S105, for the one of the at least one sub-server, according to the characteristic value and a characteristic threshold of each layer corresponding to the voltage disturbance curve of the node corresponding to the analysis task, a voltage stability analysis result of the node corresponding to the analysis task is determined.

In some implementations, the method further includes the following operation.

The characteristic threshold of each layer is determined by:

$$Th_n = \| \mu_n \|^2 + \tau^T \times J_4^{-1}$$

,

here, $Th_n$ is a characteristic threshold corresponding to a $n^{th}$ layer; $\mu_n$ is a bifurcation control parameter corresponding to the $n^{th}$ layer; $\tau^T$ is a transpose of a Lagrange multiplier $\tau$; and $J_4^{-1}$ is an inverse matrix of a characteristic value matrix $J_4$ of differential algebraic equations (DAE) for a high-proportioned renewable energy integrated power system.

In some implementations, the operation of determining, according to the characteristic value and the characteristic threshold of each layer corresponding to the voltage disturbance curve of the node corresponding to the analysis task, the voltage stability analysis result of the node corresponding to the analysis task further includes the following operations.

For a characteristic value of a layer corresponding to the voltage disturbance curve of the node corresponding to the analysis task, the voltage stability analysis result of the node corresponding to the analysis task is determined as a voltage instability node, in response to that the characteristic value of the layer is greater than or equal to a characteristic threshold of a current layer. And the voltage stability analysis result of the node corresponding to the analysis task is determined as a voltage stability node, in response to that the characteristic value of the layer is lower than the characteristic threshold of the current layer.

In the present disclosure, when a transient disturbance occurs in the voltage of the power system node and a disturbance source disappears, the voltage trajectory of the node shows a process of vibration and recovery to a stable voltage value before the fault. The transient process may be described by the DAE. The characteristic threshold of each layer is determined by:

$$Th_n = \| \mu_n \|^2 + \tau^T \times J_4^{-1}$$

,

here, $Th_n$ is the characteristic threshold corresponding to the $n^{th}$ layer; $\mu_n$ is the bifurcation control parameter corresponding to the $n^{th}$ layer; $\tau^T$ is the transpose of the Lagrange multiplier $\tau$; and $J_4^{-1}$ is the inverse matrix of the characteristic value matrix $J_4$ of the DAE for the high-proportioned renewable energy integrated power system.

In some implementations, for different nodes, the characteristic thresholds corresponding to the same layer are the same.

For the voltage disturbance curve of any node, in response to that the characteristic value of any layer is greater than or equal to the characteristic threshold of the current layer, the voltage stability analysis result of the node is determined as the voltage instability node. In response to that the characteristic value of the layer is lower than the characteristic threshold of the current layer, the voltage stability analysis result of the node is determined as the voltage stability node.

The voltage stability analysis method in the present disclosure adopts wavelet package time-frequency domain characteristic analysis. By performing signal decomposition analysis on the voltage disturbance curve of the node, the voltage curve may be decomposed into a series of decomposition signals such as a high-frequency signal, an intermediate-frequency signal and a low-frequency signal, where a one-to-one corresponding decomposition characteristic may be formed in the frequency domain level. By identifying instability characteristics of multiple-frequency bands such as a high-frequency band, an intermediate-frequency band and a low-frequency band, a reliable judgment for dynamic stability of the voltage curve can be realized.

Furthermore, it should be noted that the instability characteristics of multiple-frequency bands, such as the high-frequency band, the intermediate-frequency band and the low-frequency band, of the voltage disturbance curve of the node, are essential characteristics of the curve itself, and are not affected by external factors such as a system scale, a system access device, a system capacity and a system operation mode. The judgment method is general and may be applied to all levels of the power systems, which include a series of power generation networks, such as off-grid power systems.

Furthermore, it should be noted that, in the judgment method that is needed, the timing of an occurrence, in a time domain axis, of the instability characteristics of the multiple-frequency bands (such as, the high-frequency band, the intermediate-frequency band and the low-frequency band) of the voltage disturbance curve of the node, is positively correlated with an instability degree of the voltage of the node. That is, the deeper the dynamic instability degree of the voltage of the node, the earlier and faster the instability characteristics of the multiple-frequency bands occur. Generally, the reliable analysis and judgment for the instability characteristics may be realized within the multi-swing disturbance curve of node voltage with 50 cycles (1 second). Compared to the judgment method of traditional engineering, simulation analysis time of 10 seconds is shortened by 9 seconds, and the analysis efficiency is improved by 10 times.

Moreover, in the method, the global dynamic voltage stability analysis task of the power system is decomposed, to acquire parallel analysis tasks of multiple nodes. The parallel analysis tasks are distributed to each of the parallel nodes, to distribute part of data processing work to each of the parallel nodes. Partial processing of data is performed through the parallel nodes, and data sent to a main node is already processed. Thus, calculation and storage resources of the parallel nodes are effectively utilized, a calculation pressure problem of the main node in the dynamic voltage stability analysis can be solved, and the speed of data processing can be improved.

The present disclosure not only preliminarily processes the voltage disturbance curve by using processing capabilities of each of the parallel nodes, but also dynamically adjusts processing rules of each of the parallel nodes, and further sends the processing rules down to each of the parallel node, to realize a dynamic data processing function.

It may be understood by those skilled in the art that, in the aforementioned methods in the specific implementations, a writing sequence of the operations does not imply a strict execution sequence and constitutes any limitation on the implementation process. A specific execution sequence of the operations should be determined based on functions and possible inherent logics of the operations.

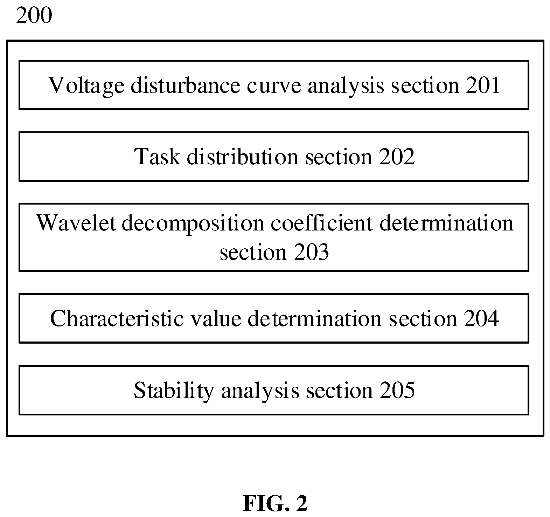

FIG. 2 is a structural diagram of a system 200 for analyzing voltage stability based on a multi-swing characteristic of a voltage disturbance curve according to an embodiment of the present disclosure. As shown in FIG. 2, the system 200 for analyzing voltage stability based on the multi-swing characteristic of the voltage disturbance curve provided by the embodiments of the present disclosure includes a voltage disturbance curve analysis section 201, a task distribution section 202, a wavelet decomposition coefficient determination section 203, a characteristic value determination section 204, and a stability analysis section 205.

In some implementations, the voltage disturbance curve analysis section 201 is configured to acquire, through a main server, a voltage disturbance curve of at least one node; and for each voltage disturbance curve, analyze, through the main server, the voltage disturbance curve based on a multi-swing characteristic, to determine analysis time and a number of processing layers for curve wavelet package decomposition corresponding to the voltage disturbance curve.

In some implementations, a type of the node includes at least one of: a load node, a direct-current (DC) station node, a capacitance node, a generator node, a phase modulator node, or a renewable energy station node.

In some implementations, the voltage disturbance curve analysis section 201 is further configured to: for each voltage disturbance curve, perform a wavelet package analysis on the multi-swing characteristic of the voltage disturbance curve, to acquire a vibration intensity of the voltage disturbance curve; and determine, according to the vibration intensity, the analysis time and the number of processing layers for curve wavelet package decomposition for the voltage disturbance curve. Here, for the voltage disturbance curve, in response to that the vibration intensity is within a first preset vibration intensity range, the analysis time corresponding to the voltage disturbance curve is determined as preset analysis time, and the number of processing layers for curve wavelet package decomposition corresponding to the voltage disturbance curve is determined as a first preset layer number. In response to that the vibration intensity is within a second preset vibration intensity range, the analysis time corresponding to the voltage disturbance curve is determined according to vibration time of the voltage disturbance curve, and the number of processing layers for curve wavelet package decomposition corresponding to the voltage disturbance curve is determined as a second preset layer number.

In some implementations, the task distribution section 202 is configured to establish, through the main server, an analysis task for each node, and distribute, through the main server, the analysis task to at least one sub-server according to a preset distribution strategy.

In some implementations, the wavelet decomposition coefficient determination section 203 is configured to perform, for one of the at least one sub-server, based on analysis time and a number of processing layers for curve wavelet package decomposition corresponding to a voltage disturbance curve of a node corresponding to an analysis task that is received, a wavelet package analysis on the voltage disturbance curve, to acquire a wavelet decomposition coefficient of each layer corresponding to the voltage disturbance curve of the node corresponding to the analysis task.

In some implementations, the wavelet decomposition coefficient determination section 203 is further configured to determine the wavelet decomposition coefficient of each layer corresponding to the voltage disturbance curve of the node corresponding to the analysis task by:

$$d_{hn} = \sum_{l=0}^{2^n-1} h_{n-2l} d_{h(2l)} + \sum_{l=0}^{2^n-1} g_{n-2l} d_{g(2l)} \, ,$$

$$d_{gn} = \sum_{l=0}^{2^n-1} h_{n-(2l+1)} d_{h(2l)} + \sum_{l=0}^{2^n-1} g_{n-(2l+1)} d_{g(2l+1)} \, ,$$

here, $d_{hn}$ is a high-frequency wavelet decomposition coefficient of a $n^{th}$ layer; $d_{gn}$ is a low-frequency wavelet decomposition coefficient of the $n^{th}$ layer; $l$ is a number of wavelet subspaces decomposed to the $n^{th}$ layer; $h_{n-2l}$, $h_{n-(2l+1)}$, $g_{n-2l}$ and $g_{n-(2l+1)}$ are general functions of real coefficient filters for wavelet analysis; $d_{h(2l)}$ is a high-frequency wavelet decomposition subspace coefficient decomposed to the $n^{th}$ layer, indicating that a high-frequency wavelet coefficient of the $n^{th}$ layer contains a combination of $2l$ subspace wavelet high-frequency coefficients; $d_{g(2l)}$ is a low-frequency wavelet decomposition subspace coefficient decomposed to the $n^{th}$ layer, indicating that the high-frequency wavelet coefficient of the $n^{th}$ layer contains a combination of $2l$ subspace wavelet low-frequency coefficients; and $d_{g(2l+1)}$ is a low-frequency wavelet decomposition subspace coefficient decomposed to the $n^{th}$ layer, indicating that a combination of $2l+1$ subspace wavelet low-frequency coefficients is further contained in the low-frequency wavelet decomposition coefficient $d_{gn}$ of the $n^{th}$ layer.

In some implementations, the characteristic value determination section 204 is configured to determine, for the one of the at least one sub-server, according to the wavelet decomposition coefficient of each layer corresponding to the voltage disturbance curve of the node corresponding to the analysis task, a characteristic value of each layer.

In some implementations, the characteristic value determination section 204 is further configured to determine, according to the wavelet decomposition coefficient of each layer corresponding to the voltage disturbance curve of the node corresponding to the analysis task, the characteristic value of each layer by:

$$E_{ntotal} = E_{hn} + E_{gn} \, ,$$

$$E_{hn} = \sqrt{2} \sum_{k=0}^{n} d_{hn} u_{2n}(2t-k) f_{hn}(t) \, ,$$

$$E_{gn} = \sqrt{2} \sum_{k=0}^{n} d_{gn} u_{2n}(2t-k) f_{gn}(t) \, ,$$

$$\mu_{2n}(2t-k) = \frac{2\xi^2}{f_p^3 \sqrt{\pi}} e^{\left(-\frac{\xi^2}{f_p^2}\right)} e^{-j2\pi\xi(2t-k)} \, ,$$

here, $E_{ntotal}$ is a characteristic value of a n$^{th}$ layer; $E_{hn}$ and $E_{gn}$ are characteristic values of high-frequency and low-frequency wavelets of the n$^{th}$ layer respectively; $d_{hn}$ is a high-frequency wavelet decomposition coefficient of the n$^{th}$ layer; $d_{gn}$ is a low-frequency wavelet decomposition coefficient of the n$^{th}$ layer; $f(t)$ is a function formed by voltage disturbance curve data to be analyzed, and $t$ is analysis time; $f_{hn}(t)$ is a high-frequency decomposition function of the n$^{th}$ layer at a moment $t$, and $f_{gn}(t)$ is a low-frequency decomposition function of the n$^{th}$ layer at the moment $t$; $\mu_{2n}(2t - k)$ is a wavelet package generating function determined by an orthogonal scaling function, $t$ is the analysis time, $k$ is a number of wavelet subspaces, and $f_p$ is a fluctuation frequency of the disturbance curve; $\xi$ is a truncation error coefficient of wavelet decomposition; and $j$ represents an imaginary part.

In some implementations, the stability analysis section 205 is configured to determine, for the one of the at least one sub-server, according to the characteristic value and a characteristic threshold of each layer corresponding to the voltage disturbance curve of the node corresponding to the analysis task, a voltage stability analysis result of the node corresponding to the analysis task.

In some implementations, the system further includes a characteristic threshold determination section, and the characteristic threshold determination section is configured to determine the characteristic threshold of each layer by:

$$Th_n = \| \mu_n \|^2 + \tau^T \times J_4^{-1},$$

here, $Th_n$ is a characteristic threshold corresponding to a n$^{th}$ layer; $\mu_n$ is a bifurcation control parameter corresponding to the n$^{th}$ layer; $\tau^T$ is a transpose of a Lagrange multiplier $\tau$; and $J_4^{-1}$ is an inverse matrix of a characteristic value matrix $J_4$ of differential algebraic equations (DAE) for a high-proportioned renewable energy integrated power system.

In some implementations, the stability analysis section 205 is further configured to: for a characteristic value of a layer corresponding to the voltage disturbance curve of the node corresponding to the analysis task, determine the voltage stability analysis result of the node corresponding to the analysis task as a voltage instability node, in response to that the characteristic value of the layer is greater than or equal to a characteristic threshold of a current layer; and determine the voltage stability analysis result of the node corresponding to the analysis task as a voltage stability node, in response to that the characteristic value of the layer is lower than the characteristic threshold of the current layer.

The system 200 for analyzing voltage stability based on the multi-swing characteristic of the voltage disturbance curve in the embodiments of the present disclosure corresponds to the method 100 for analyzing voltage stability based on the multi-swing characteristic of the voltage disturbance curve in other embodiments of the present disclosure.

In the embodiments of the present disclosure and other embodiments, a term "part" may be a portion of a circuit, a portion of a processor, a portion of a program or software or the like, which may of course be a unit, a module or a non-modular.

The present disclosure provides a computer-readable storage medium, which may be transitory or non-transitory storage medium. A computer program is stored thereon, and when executed by a processor, the computer program is enables the processor to implement any one of the operations of the method for analyzing voltage stability based on the multi-swing characteristic of the voltage disturbance curve.

The present disclosure provides an electronic device. The electronic device includes the computer-readable storage medium above, and one or more processors configured to execute a program in the computer-readable storage medium.

The present disclosure has been described with reference to a few implementations. However, other embodiments which are well known to those skilled in the art other than the embodiments disclosed above still fall within the scope of the present disclosure.

Generally, all terms used in the present disclosure are interpreted according to their general meanings in the art, unless otherwise explicitly defined therein. All references to "one/said/the [apparatus, component, etc.]" are openly interpreted as at least one instance of the apparatus, component, etc., unless otherwise explicitly stated. The operations of any method disclosed herein are not necessary to be executed in an exact order disclosed, unless explicitly stated.

It should be understood by those skilled in the art that the embodiments of the present disclosure may be provided as methods, systems or computer program products. Therefore, the present disclosure may take forms of embodiments with entirely hardware, embodiments with entirely software, or embodiments combining software with hardware aspects. Furthermore, the present disclosure may take a form of a computer program product implemented on one or more computer-available storage media (including, but not limited to a disk storage, a Compact Disk Read Only Memory (CD-ROM), an optical storage, etc.) containing computer-available program codes therein.

The present disclosure is described with reference to flowcharts and/or block diagrams of methods, devices (systems) and computer program products according to the embodiments of the present disclosure. It should be understood that computer program instructions may implement each flow and/or block in the flowcharts and/or the block diagrams, as well as combinations of flows and/or blocks in the flowcharts and/or the block diagrams. These computer program instructions may be provided to processors of a general purpose computer, a specialized computer, an embedded processor or other programmable data processing devices to generate a machine, such that instructions executed by the processors of the computer or other programmable data processing devices generate an apparatus configured to implement functions specified in one or more flows of the flowcharts and/or one or more blocks of the block diagrams.

Such computer program instructions may also be stored in a computer-readable memory which can guide a computer or other programmable data processing devices to operate in a specific manner, such that the instructions stored in the computer-readable memory generate a manufactured product including an instruction apparatus. The instruction apparatus implements functions specified in one or more flows of the flowcharts and/or one or more blocks of the block diagrams.

Such computer program instructions may further be loaded onto a computer or other programmable data processing devices, such that a series of operations are executed on the computer or other programmable devices to generate computer-implemented processing. Thus, the instructions executed on the computer or other programmable devices provide operations for implementing functions specified in one or more flows of the flowcharts and/or one or more blocks of the block diagrams.

Finally, it should be noted that the aforementioned embodiments are used to illustrate the technical solutions of the present disclosure, but not to limit the present disclosure. Although the present disclosure has been described in detail with reference to the aforementioned embodiments, it should be understood by those of ordinary skill in the art that modifications or equivalent replacements may be made to the specific embodiments of the present disclosure, and any modification or equivalent replacement not departing from the scope of the present disclosure should be covered within the scope of protection of the present appended claims.

Industrial Applicability

The embodiments of the present disclosure provides a method and system for analyzing voltage stability based on a multi-swing characteristic of a voltage disturbance curve, an electronic device, a storage medium, and a computer program product. The method for analyzing voltage stability includes the following operations. A main server acquires a voltage disturbance curve of at least one node; and for each voltage disturbance curve, the main server analyzes the voltage disturbance curve based on a multi-swing characteristic, to determine analysis time and a number of processing layers for curve wavelet package decomposition corresponding to the voltage disturbance curve. The main server establishes an analysis task for each node, and distributes the analysis task to at least one sub-server according to a preset distribution strategy. For one of the at least one sub-server, based on analysis time and the number of processing layers for curve wavelet package decomposition corresponding to a voltage disturbance curve of a node corresponding to an analysis task that is received, a wavelet package analysis is performed on the voltage disturbance curve, to acquire a wavelet decomposition coefficient of each layer corresponding to the voltage disturbance curve of the node corresponding to the analysis task. For the one of the at least one sub-server, according to the wavelet decomposition coefficient of each layer corresponding to the voltage disturbance curve of the node corresponding to the analysis task, a characteristic value of each layer is determined. Additionally, for the one of the at least one sub-server, according to the characteristic value and a characteristic threshold of each layer corresponding to the voltage disturbance curve of the node corresponding to the analysis task, a voltage stability analysis result of the node corresponding to the analysis task is determined. The present disclosure analyzes, based on a parallel calculation manner, a voltage disturbance curve of a power system node under a fault by using a wavelet package decomposition method; and further performs stability analysis according to the acquired characteristic value. Thus, a fast, effective and reliable voltage stability judgment can be realized.

**Claims**

1. A method for analyzing voltage stability based on a multi-swing characteristic of a voltage disturbance curve, **characterized by** comprising:

   acquiring (S101), by a main server, a voltage disturbance curve of at least one node, and for each voltage disturbance curve, analyzing the voltage disturbance curve based on a multi-swing characteristic, to determine analysis time and a number of processing layers for curve wavelet package decomposition corresponding to the voltage disturbance curve;
   establishing (S102), by the main server, an analysis task for each node, and distributing the analysis task to at least one sub-server according to a preset distribution strategy;
   performing (S103), for one of the at least one sub-server, based on analysis time and a number of processing layers for curve wavelet package decomposition corresponding to a voltage disturbance curve of a node corresponding to an analysis task that is received, a wavelet package analysis on the voltage disturbance curve, to acquire a wavelet decomposition coefficient of each layer corresponding to the voltage disturbance curve of the node corresponding to the analysis task;

determining (S104), for the one of the at least one sub-server, according to the wavelet decomposition coefficient of each layer corresponding to the voltage disturbance curve of the node corresponding to the analysis task, a characteristic value of each layer; and

determining (S105), for the one of the at least one sub-server, according to the characteristic value and a characteristic threshold of each layer corresponding to the voltage disturbance curve of the node corresponding to the analysis task, a voltage stability analysis result of the node corresponding to the analysis task.

2. The method of claim 1, wherein a type of the node comprises at least one of: a load node, a direct-current, DC, station node, a capacitance node, a generator node, a phase modulator node, or a renewable energy station node.

3. The method of claim 1, wherein analyzing the voltage disturbance curve based on the multi-swing characteristic, to determine the analysis time and the number of processing layers for curve wavelet package decomposition corresponding to the voltage disturbance curve comprises:

for each voltage disturbance curve, performing a wavelet package analysis on the multi-swing characteristic of the voltage disturbance curve, to acquire a vibration intensity of the voltage disturbance curve; and

determining, according to the vibration intensity, the analysis time and the number of processing layers for curve wavelet package decomposition for the voltage disturbance curve;

wherein, for the voltage disturbance curve, in response to that the vibration intensity is within a first preset vibration intensity range, the analysis time corresponding to the voltage disturbance curve is determined as preset analysis time, and the number of processing layers for curve wavelet package decomposition corresponding to the voltage disturbance curve is determined as a first preset layer number; in response to that the vibration intensity is within a second preset vibration intensity range, the analysis time corresponding to the voltage disturbance curve is determined according to vibration time of the voltage disturbance curve, and the number of processing layers for curve wavelet package decomposition corresponding to the voltage disturbance curve is determined as a second preset layer number.

4. The method of claim 1, wherein the wavelet decomposition coefficient of each layer corresponding to the voltage disturbance curve of the node corresponding to the analysis task is determined by:

$$d_{hn} = \sum_{l=0}^{2^n-1} h_{n-2l} d_{h(2l)} + \sum_{l=0}^{2^n-1} g_{n-2l} d_{g(2l)},$$

$$d_{gn} = \sum_{l=0}^{2^n-1} h_{n-(2l+1)} d_{h(2l)} + \sum_{l=0}^{2^n-1} g_{n-(2l+1)} d_{g(2l+1)},$$

wherein $d_{hn}$ is a high-frequency wavelet decomposition coefficient of a $n^{th}$ layer; $d_{gn}$ is a low-frequency wavelet decomposition coefficient of the $n^{th}$ layer; $l$ is a number of wavelet subspaces decomposed to the $n^{th}$ layer; $h_{n-2l}$, $h_{n-(2l+1)}$, $g_{n-2l}$ and $g_{n-(2l+1)}$ are general functions of real coefficient filters for wavelet analysis; $d_{h(2l)}$ is a high-frequency wavelet decomposition subspace coefficient decomposed to the $n^{th}$ layer, indicating that a high-frequency wavelet coefficient of the $n^{th}$ layer contains a combination of $2l$ subspace wavelet high-frequency coefficients; $d_{g(2l)}$ is a low-frequency wavelet decomposition subspace coefficient decomposed to the $n^{th}$ layer, indicating that the high-frequency wavelet coefficient of the $n^{th}$ layer contains a combination of $2l$ subspace wavelet low-frequency coefficients; and $d_{g(2l+1)}$ is a low-frequency wavelet decomposition subspace coefficient decomposed to the $n^{th}$ layer, indicating that a combination of $2l+1$ subspace wavelet low-frequency coefficients is further contained in the low-frequency wavelet decomposition coefficient $d_{gn}$ of the $n^{th}$ layer.

5. The method of claim 1, wherein the characteristic value of each layer is determined, according to the wavelet decomposition coefficient of each layer corresponding to the voltage disturbance curve of the node corresponding to the analysis task, by:

$$E_{ntotal} = E_{hn} + E_{gn},$$

$$E_{hn} = \sqrt{2} \sum_{k=0}^{n} d_{hn} \mu_{2n}(2t-k) f_{hn}(t),$$

$$E_{gn} = \sqrt{2} \sum_{k=0}^{n} d_{gn} \mu_{2n}(2t-k) f_{gn}(t),$$

$$\mu_{2n}(2t-k) = \frac{2\xi^2}{f_p^3 \sqrt{\pi}} e^{(-\frac{\xi^2}{f_p^2})} e^{-j2\pi\xi(2t-k)},$$

wherein $E_{ntotal}$ is a characteristic value of a $n^{th}$ layer; $E_{hn}$ and $E_{gn}$ are characteristic values of high-frequency and low-frequency wavelets of the $n^{th}$ layer respectively; $d_{hn}$ is a high-frequency wavelet decomposition coefficient of the $n^{th}$ layer; $d_{gn}$ is a low-frequency wavelet decomposition coefficient of the $n^{th}$ layer; $f(t)$ is a function formed by voltage disturbance curve data to be analyzed, and $t$ is analysis time; $f_{hn}(t)$ is a high-frequency decomposition function of the $n^{th}$ layer at a moment $t$, and $f_{gn}(t)$ is a low-frequency decomposition function of the $n^{th}$ layer at the moment $t$; $\mu_{2n}(2t-k)$ is a wavelet package generating function determined by an orthogonal scaling function, $t$ is the analysis time, $k$ is a number of wavelet subspaces, and $f_p$ is a fluctuation frequency of the disturbance curve; $\xi$ is a truncation error coefficient of wavelet decomposition; and $j$ represents an imaginary part.

6. The method of claim 1, further comprising:

   determining the characteristic threshold of each layer by:

   $$Th_n = \| \mu_n \|^2 + \tau^T \times J_4^{-1},$$

   wherein $Th_n$ is a characteristic threshold corresponding to a $n^{th}$ layer; $\mu_n$ is a bifurcation control parameter corresponding to the $n^{th}$ layer; $\tau^T$ is a transpose of a Lagrange multiplier $\tau$; and $J_4^{-1}$ is an inverse matrix of a characteristic value matrix $J_4$ of differential algebraic equations, DAE, for a high-proportioned renewable energy integrated power system.

7. The method of claim 1, wherein determining, according to the characteristic value and the characteristic threshold of each layer corresponding to the voltage disturbance curve of the node corresponding to the analysis task, the voltage stability analysis result of the node corresponding to the analysis task, comprises:
   for a characteristic value of a layer corresponding to the voltage disturbance curve of the node corresponding to the analysis task, determining the voltage stability analysis result of the node corresponding to the analysis task as a voltage instability node, in response to that the characteristic value of the layer is greater than or equal to a characteristic threshold of a current layer; and determining the voltage stability analysis result of the node corresponding to the analysis task as a voltage stability node, in response to that the characteristic value of the layer is lower than the characteristic threshold of the current layer.

8. A system for analyzing voltage stability based on a multi-swing characteristic of a voltage disturbance curve, **characterized by** comprising:

   a voltage disturbance curve analysis section (201), configured to acquire, through a main server, a voltage disturbance curve of at least one node; and for each voltage disturbance curve, analyze, through the main server, the voltage disturbance curve based on a multi-swing characteristic, to determine analysis time and a number of processing layers for curve wavelet package decomposition corresponding to the voltage disturbance curve;

a task distribution section (202), configured to establish, through the main server, an analysis task for each node, and distribute, through the main server, the analysis task to at least one sub-server according to a preset distribution strategy;

a wavelet decomposition coefficient determination section (203), configured to perform, for one of the at least one sub-server, based on analysis time and a number of processing layers for curve wavelet package decomposition corresponding to a voltage disturbance curve of a node corresponding to an analysis task that is received, a wavelet package analysis on the voltage disturbance curve, to acquire a wavelet decomposition coefficient of each layer corresponding to the voltage disturbance curve of the node corresponding to the analysis task;

a characteristic value determination section (204), configured to determine, for the one of the at least one sub-server, according to the wavelet decomposition coefficient of each layer corresponding to the voltage disturbance curve of the node corresponding to the analysis task, a characteristic value of each layer; and

a stability analysis section (205), configured to determine, for the one of the at least one sub-server, according to the characteristic value and a characteristic threshold of each layer corresponding to the voltage disturbance curve of the node corresponding to the analysis task, a voltage stability analysis result of the node corresponding to the analysis task.

9. The system of claim 8, wherein a type of the node comprises at least one of: a load node, a direct-current, DC, station node, a capacitance node, a generator node, a phase modulator node, or a renewable energy station node.

10. The system of claim 8, wherein the voltage disturbance curve analysis section is further configured to:

for each voltage disturbance curve, perform a wavelet package analysis on the multi-swing characteristic of the voltage disturbance curve, to acquire a vibration intensity of the voltage disturbance curve; and

determine, according to the vibration intensity, the analysis time and the number of processing layers for curve wavelet package decomposition for the voltage disturbance curve;

wherein, for the voltage disturbance curve, in response to that the vibration intensity is within a first preset vibration intensity range, the analysis time corresponding to the voltage disturbance curve is determined as preset analysis time, and the number of processing layers for curve wavelet package decomposition corresponding to the voltage disturbance curve is determined as a first preset layer number; and in response to that the vibration intensity is within a second preset vibration intensity range, the analysis time corresponding to the voltage disturbance curve is determined according to vibration time of the voltage disturbance curve, and the number of processing layers for curve wavelet package decomposition corresponding to the voltage disturbance curve is determined as a second preset layer number.

11. The system of claim 8, wherein the wavelet decomposition coefficient determination section is further configured to determine the wavelet decomposition coefficient of each layer corresponding to the voltage disturbance curve of the node corresponding to the analysis task by:

$$d_{hn} = \sum_{l=0}^{2^n-1} h_{n-2l} d_{h(2l)} + \sum_{l=0}^{2^n-1} g_{n-2l} d_{g(2l)},$$

$$d_{gn} = \sum_{l=0}^{2^n-1} h_{n-(2l+1)} d_{h(2l)} + \sum_{l=0}^{2^n-1} g_{n-(2l+1)} d_{g(2l+1)},$$

wherein $d_{hn}$ is a high-frequency wavelet decomposition coefficient of a $n^{th}$ layer; $d_{gn}$ is a low-frequency wavelet decomposition coefficient of the $n^{th}$ layer; $l$ is a number of wavelet subspaces decomposed to the $n^{th}$ layer; $h_{n-2l}$, $h_{n-(2l+1)}$, $g_{n-2l}$ and $g_{n-(2l+1)}$ are general functions of real coefficient filters for wavelet analysis; $d_{h(2l)}$ is a high-frequency wavelet decomposition subspace coefficient decomposed to the $n^{th}$ layer, indicating that a high-frequency wavelet coefficient of the $n^{th}$ layer contains a combination of $2l$ subspace wavelet high-frequency coefficients; $d_{g(2l)}$ is a low-frequency wavelet decomposition subspace coefficient decomposed to the $n^{th}$ layer, indicating that the high-frequency wavelet coefficient of the $n^{th}$ layer contains a combination of $2l$ subspace wavelet low-frequency coefficients; and $d_{g(2l+1)}$ is a low-frequency wavelet decomposition subspace coefficient decomposed to the $n^{th}$ layer, indicating that a combination of $2l+1$ subspace wavelet low-frequency coefficients is further contained in the low-frequency wavelet decomposition coefficient $d_{gn}$ of the n<sup>th</sup> layer.

12. The system of claim 8, wherein the characteristic value determination section is further configured to determine, according to the wavelet decomposition coefficient of each layer corresponding to the voltage disturbance curve of the node corresponding to the analysis task, the characteristic value of each layer by:

$$E_{ntotal} = E_{hn} + E_{gn},$$

$$E_{hn} = \sqrt{2} \sum_{k=0}^{n} d_{hn} \mu_{2n}(2t - k) f_{hn}(t),$$

$$E_{gn} = \sqrt{2} \sum_{k=0}^{n} d_{gn} \mu_{2n}(2t - k) f_{gn}(t),$$

$$\mu_{2n}(2t - k) = \frac{2\xi^2}{f_p^3 \sqrt{\pi}} e^{(-\frac{\xi^2}{f_p^2})} e^{-j 2\pi\xi(2t-k)},$$

wherein $E_{ntotal}$ is a characteristic value of a n<sup>th</sup> layer; $E_{hn}$ and $E_{gn}$ are characteristic values of high-frequency and low-frequency wavelets of the n<sup>th</sup> layer respectively; $d_{hn}$ is a high-frequency wavelet decomposition coefficient of the n<sup>th</sup> layer; $d_{gn}$ is a low-frequency wavelet decomposition coefficient of the n<sup>th</sup> layer; $f(t)$ is a function formed by voltage disturbance curve data to be analyzed, and $t$ is analysis time; $f_{hn}(t)$ is a high-frequency decomposition function of the n<sup>th</sup> layer at a moment $t$, and $f_{gn}(t)$ is a low-frequency decomposition function of the n<sup>th</sup> layer at the moment $t$; $\mu_{2n}(2t-k)$ is a wavelet package generating function determined by an orthogonal scaling function, $t$ is the analysis time, $k$ is a number of wavelet subspaces, and $f_p$ is a fluctuation frequency of the disturbance curve; $\xi$ is a truncation error coefficient of wavelet decomposition; and $j$ represents an imaginary part.

13. The system of claim 8, further comprising a characteristic threshold determination section, configured to:

determine the characteristic threshold of each layer by:

$$Th_n = \| \mu_n \|^2 + \tau^T \times J_4^{-1},$$

wherein $Th_n$ is a characteristic threshold corresponding to a n<sup>th</sup> layer; $\mu_n$ is a bifurcation control parameter corresponding to the n<sup>th</sup> layer; $\tau^T$ is a transpose of a Lagrange multiplier $\tau$; and $J_4^{-1}$ is an inverse matrix of a characteristic value matrix $J_4$ of differential algebraic equations, DAE, for a high-proportioned renewable energy integrated power system.

14. The system of claim 8, wherein the stability analysis section is further configured to:
for a characteristic value of a layer corresponding to the voltage disturbance curve of the node corresponding to the analysis task, determine the voltage stability analysis result of the node corresponding to the analysis task as a voltage instability node in response to that the characteristic value of the layer is greater than or equal to a characteristic threshold of a current layer; and determine the voltage stability analysis result of the node corresponding to the analysis task as a voltage stability node in response to that the characteristic value of the layer is lower than the characteristic threshold of the current layer.

15. A computer-readable storage medium having stored thereon a computer program that, when executed by a processor, enables the processor to implement operations of the method of any one of claims 1 to 7.

**16.** An electronic device, comprising:

the computer-readable storage medium of claim 15; and
one or more processors configured to execute a program in the computer-readable storage medium.

**17.** A computer program product, comprising a computer program or instruction that, when running on an electronic device, enables the electronic device to implement the method of any one of claims 1 to 7.


**Patentansprüche**

**1.** Verfahren zum Analysieren der Spannungsstabilität basierend auf einer Mehrfachschwingungscharakteristik einer Spannungsstörungskurve,
**dadurch gekennzeichnet, dass** es umfasst:

Erfassen (S101), durch einen Hauptserver, einer Spannungsstörungskurve mindestens eines Knotens, und für jede Spannungsstörungskurve, Analysieren der Spannungsstörungskurve basierend auf einer Mehrfachschwingungscharakteristik, um eine Analysezeit und eine Anzahl von Verarbeitungsschichten für eine Kurven-Wavelet-Paket-Zerlegung entsprechend der Spannungsstörungskurve zu bestimmen;
Erstellen (S102), durch den Hauptserver, einer Analyseaufgabe für jeden Knoten und Verteilen der Analyseaufgabe an mindestens einen untergeordneten Server gemäß einer voreingestellten Verteilungsstrategie;
Durchführen (S103), für einen des mindestens einen untergeordneten Servers, basierend auf einer Analysezeit und einer Anzahl von Verarbeitungsschichten für eine Kurven-Wavelet-Paket-Zerlegung entsprechend einer Spannungsstörungskurve eines Knotens entsprechend einer Analyseaufgabe, die empfangen wird, einer Wavelet-Paket-Analyse an der Spannungsstörungskurve, um einen Wavelet-Zerlegungskoeffizienten jeder Schicht entsprechend der Spannungsstörungskurve des Knotens entsprechend der Analyseaufgabe, zu erfassen;
Bestimmen (S104), für den einen des mindestens einen untergeordneten Servers, gemäß dem Wavelet-Zerlegungskoeffizienten jeder Schicht entsprechend der Spannungsstörungskurve des Knotens entsprechend der Analyseaufgabe, eines charakteristischen Werts jeder Schicht; und
Bestimmen (S105) für den einen des mindestens einen untergeordneten Servers, gemäß dem charakteristischen Wert und einer charakteristischen Schwelle jeder Schicht entsprechend der Spannungsstörungskurve des Knotens entsprechend der Analyseaufgabe, eines Spannungsstabilitätsanalyseergebnisses des Knotens entsprechend der Analyseaufgabe.

**2.** Verfahren nach Anspruch 1, wobei ein Typ des Knotens mindestens eines umfasst von: einem Lastknoten, einem Gleichstrom-Stationsknoten, DC-Stationsknoten, einem Kapazitätsknoten, einem Generatorknoten, einem Phasenmodulatorknoten oder einem Stationsknoten für erneuerbare Energien.

**3.** Verfahren nach Anspruch 1, wobei das Analysieren der Spannungsstörungskurve basierend auf der Mehrfachschwingungscharakteristik, um die Analysezeit und die Anzahl der Verarbeitungsschichten für die Kurven-Wavelet-Paket-Zerlegung entsprechend der Spannungsstörungskurve zu bestimmen, umfasst:

für jede Spannungsstörungskurve, Durchführen einer Wavelet-Paket-Analyse an der Mehrschwingungscharakteristik der Spannungsstörungskurve, um eine Vibrationsintensität der Spannungsstörungskurve zu erfassen; und
Bestimmen, gemäß der Vibrationsintensität, der Analysezeit und der Anzahl von Verarbeitungsschichten für die Kurven-Wavelet-Paket-Zerlegung für die Spannungsstörungskurve;
wobei für die Spannungsstörungskurve als Reaktion darauf, dass die Vibrationsintensität innerhalb eines ersten voreingestellten Vibrationsintensitätsbereichs liegt, die Analysezeit entsprechend der Spannungsstörungskurve als voreingestellte Analysezeit bestimmt wird, und die Anzahl der Verarbeitungsschichten für die Kurven-Wavelet-Paket-Zerlegung entsprechend der Spannungsstörungskurve als eine erste voreingestellte Schichtanzahl bestimmt wird; als Reaktion darauf, dass die Schwingungsintensität innerhalb eines zweiten voreingestellten Schwingungsintensitätsbereichs liegt, die Analysezeit entsprechend der Spannungsstörungskurve gemäß der Vibrationszeit der Spannungsstörungskurve bestimmt wird, und die Anzahl der Verarbeitungsschichten für die Kurven-Wavelet-Paket-Zerlegung entsprechend der Spannungsstörungskurve als eine zweite voreingestellte Schichtanzahl bestimmt wird.

4. Verfahren nach Anspruch 1, wobei der Wavelet-Zerlegungskoeffizient jeder Schicht entsprechend der Spannungsstörungskurve des Knotens entsprechend der Analyseaufgabe bestimmt wird, durch:

$$d_{hn} = \sum_{l=0}^{2^n-1} h_{n-2l} d_{h(2l)} + \sum_{l=0}^{2^n-1} g_{n-2l} d_{g(2l)},$$

$$d_{gn} = \sum_{l=0}^{2^n-1} h_{n-(2l+1)} d_{h(2l)} + \sum_{l=0}^{2^n-1} g_{n-(2l+1)} d_{g(2l+1)},$$

wobei $d_{hn}$ ein Hochfrequenz-Wavelet-Zerlegungskoeffizient einer $n^{ten}$ Schicht ist; $d_{gn}$ ein Niederfrequenz-Wavelet-Zerlegungskoeffizient der $n^{ten}$ Schicht ist; $l$ eine Anzahl von Wavelet-Teilräumen ist, die zu der $n^{ten}$ Schicht zerlegt sind; $h_{n-2l}$, $h_{n-(2l+1)}$, $g_{n-2l}$ und $g_{n-(2l+1)}$ allgemeine Funktionen von Realkoeffizientenfiltern für die Wavelet-Analyse sind; $d_{h(2l)}$ ein Hochfrequenz-Wavelet-Zerlegungs-Teilraumkoeffizient ist, der zu der $n^{ten}$ Schicht zerlegt wird, wobei angegeben wird, dass ein Hochfrequenz-Wavelet-Koeffizient der $n^{ten}$ Schicht eine Kombination von $2l$ Teilraum-Wavelet-Hochfrequenzkoeffizienten enthält; $d_{g(2l)}$ ein Niederfrequenz-Wavelet-Zerlegungs-Teilraumkoeffizient ist, der zu der $n^{ten}$ Schicht zerlegt wird, wobei angegeben wird, dass der Hochfrequenz-Wavelet-Koeffizient der $n^{ten}$ Schicht eine Kombination von $2l$ Teilraum-Wavelet-Niederfrequenzkoeffizienten enthält; und $d_{g(2l+1)}$ ein Niederfrequenz-Wavelet-Zerlegungs-Teilraumkoeffizient ist, der zu der $n^{ten}$ Schicht zerlegt wird, wobei angegeben wird, dass eine Kombination von $2l+1$ Teilraum-Wavelet-Niederfrequenzkoeffizienten weiterhin in dem Niederfrequenz-Wavelet-Zerlegungskoeffizienten $d_{gn}$ der $n^{ten}$ Schicht enthalten ist.

5. Verfahren nach Anspruch 1, wobei der charakteristische Wert jeder Schicht bestimmt wird, gemäß dem Wavelet-Zerlegungskoeffizienten jeder Schicht entsprechend der Spannungsstörungskurve des Knotens entsprechend der Analyseaufgabe, durch:

$$E_{ntotal} = E_{hn} + E_{gn},$$

$$E_{hn} = \sqrt{2} \sum_{k=0}^{n} d_{hn} \mu_{2n}(2t-k) f_{hn}(t),$$

$$E_{gn} = \sqrt{2} \sum_{k=0}^{n} d_{gn} \mu_{2n}(2t-k) f_{gn}(t),$$

$$\mu_{2n}(2t-k) = \frac{2\xi^2}{f_p^3 \sqrt{\pi}} e^{\left(-\frac{\xi^2}{f_p^2}\right)} e^{-j2\pi\xi(2t-k)},$$

wobei $E_{ntotal}$ ein charakteristischer Wert einer $n^{ten}$ Schicht ist; $E_{hn}$ und $E_{gn}$ charakteristische Werte von Hochfrequenz- bzw. Niederfrequenz-Wavelets der $n^{ten}$ Schicht sind; $d_{hn}$ ein Hochfrequenz-Wavelet-Zerlegungskoeffizient der $n^{ten}$ Schicht ist; $d_{gn}$ ein Niederfrequenz-Wavelet-Zerlegungskoeffizient der $n^{ten}$ Schicht ist; $f(t)$ eine Funktion ist, die durch zu analysierende Spannungsstörungskurvendaten ausgebildet wird, und $t$ die Analysezeit ist; $f_{hn}(t)$ eine Hochfrequenz-Zerlegungsfunktion der $n^{ten}$ Schicht zu einem Zeitpunkt $t$ ist und $f_{gn}(t)$ eine Niederfrequenz-Zerlegungsfunktion der $n^{ten}$ Schicht zu dem Zeitpunkt $t$ ist; $\mu_{2n}(2t-k)$ eine Wavelet-Paket-Generierungsfunktion ist, die durch eine orthogonale Skalierungsfunktion bestimmt wird, $t$ die Analysezeit ist, $k$ eine Anzahl von Wavelet-Teilräumen ist und $f_p$ eine Schwankungsfrequenz der Störungskurve ist; $\xi$ ein Abbruchfehlerkoeffizient der Wavelet-Zerlegung ist; und $j$ einen imaginären Teil darstellt.

6. Verfahren nach Anspruch 1, ferner umfassend:

Bestimmen der charakteristischen Schwelle jeder Schicht durch:

$$Th_n = \| \mu_n \|^2 + \tau^T \times J_4^{-1},$$

wobei $Th_n$ eine charakteristische Schwelle entsprechend einer n^ten Schicht ist; $\mu_n$ ein Bifurkationssteuerparameter entsprechend der n^ten Schicht ist; $\tau^T$ eine Transponierte eines Lagrange-Multiplikators $\tau$ ist; und $J_4^{-1}$ eine inverse Matrix einer charakteristischen Wertmatrix $J_4$ von Differential-Algebraischen Gleichungen, DAE, für ein integriertes Leistungssystem mit hohem Anteil erneuerbarer Energien ist.

7. Verfahren nach Anspruch 1, wobei das Bestimmen, gemäß dem charakteristischen Wert und der charakteristischen Schwelle jeder Schicht entsprechend der Spannungsstörungskurve des Knotens entsprechend der Analyseaufgabe, des Spannungsstabilitätsanalyseergebnisses des Knotens entsprechend der Analyseaufgabe, umfasst:
für einen charakteristischen Wert einer Schicht entsprechend der Spannungsstörungskurve des Knotens entsprechend der Analyseaufgabe, Bestimmen des Spannungsstabilitätsanalyseergebnisses des Knotens entsprechend der Analyseaufgabe als einen Spannungsinstabilitätsknoten, als Reaktion darauf, dass der charakteristische Wert der Schicht größer als oder gleich einer charakteristischen Schwelle einer aktuellen Schicht ist; und Bestimmen des Spannungsstabilitätsanalyseergebnisses des Knotens entsprechend der Analyseaufgabe als einen Spannungsstabilitätsknoten, als Reaktion darauf, dass der charakteristische Wert der Schicht niedriger als die charakteristische Schwelle der aktuellen Schicht ist.

8. System zum Analysieren der Spannungsstabilität basierend auf einer Mehrfachschwingungscharakteristik einer Spannungsstörungskurve, das **dadurch gekennzeichnet ist, dass** es umfasst:

einen Spannungsstörungskurven-Analyseabschnitt (201), der konfiguriert ist, um über einen Hauptserver eine Spannungsstörungskurve mindestens eines Knotens zu erfassen; und für jede Spannungsstörungskurve, Analysieren, über den Hauptserver, der Spannungsstörungskurve basierend auf einer Mehrfachschwingungscharakteristik, um die Analysezeit und eine Anzahl von Verarbeitungsschichten für die Kurven-Wavelet-Paket-Zerlegung entsprechend der Spannungsstörungskurve zu bestimmen;
einen Aufgabenverteilungsabschnitt (202), der konfiguriert ist, um über den Hauptserver eine Analyseaufgabe für jeden Knoten zu erstellen und über den Hauptserver die Analyseaufgabe an mindestens einen untergeordneten Server gemäß einer voreingestellten Verteilungsstrategie zu verteilen;
einen Wavelet-Zerlegungskoeffizienten-Bestimmungsabschnitt (203), der konfiguriert ist, um für einen des mindestens einen untergeordneten Servers, basierend auf der Analysezeit und einer Anzahl von Verarbeitungsschichten für eine Kurven-Wavelet-Paket-Zerlegung entsprechend einer Spannungsstörungskurve eines Knotens entsprechend einer Analyseaufgabe, die empfangen wird, eine Wavelet-Paket-Analyse an der Spannungsstörungskurve durchzuführen, um einen Wavelet-Zerlegungskoeffizienten jeder Schicht entsprechend der Spannungsstörungskurve des Knotens entsprechend der Analyseaufgabe zu erfassen;
einen Bestimmungsabschnitt (204) für einen charakteristischen Wert, der konfiguriert ist, um für den einen des mindestens einen untergeordneten Servers gemäß dem Wavelet-Zerlegungskoeffizienten jeder Schicht entsprechend der Spannungsstörungskurve des Knotens entsprechend der Analyseaufgabe, einen charakteristischen Wert jeder Schicht zu bestimmen; und
einen Stabilitätsanalyseabschnitt (205), der konfiguriert ist, um für den einen des mindestens einen untergeordneten Servers gemäß dem charakteristischen Wert und einer charakteristischen Schwelle jeder Schicht entsprechend der Spannungsstörungskurve des Knotens entsprechend der Analyseaufgabe, ein Spannungsstabilitätsanalyseergebnis des Knotens entsprechend der Analyseaufgabe, zu bestimmen.

9. System nach Anspruch 8, wobei ein Typ des Knotens mindestens eines umfasst von: einem Lastknoten, einem Gleichstrom-Stationsknoten, DC-Stationsknoten, einem Kapazitätsknoten, einem Generatorknoten, einem Phasenmodulatorknoten oder einem Stationsknoten für erneuerbare Energien.

10. System nach Anspruch 8, wobei der Spannungsstörungskurven-Analyseabschnitt ferner konfiguriert ist zum:

für jede Spannungsstörungskurve, Durchführen einer Wavelet-Paket-Analyse an der Mehrfachschwingungscharakteristik der Spannungsstörungskurve, um eine Vibrationsintensität der Spannungsstörungskurve zu erhalten; und

Bestimmen, gemäß der Vibrationsintensität, der Analysezeit und der Anzahl von Verarbeitungsschichten für die Kurven-Wavelet-Paket-Zerlegung für die Spannungsstörungskurve;

wobei für die Spannungsstörungskurve als Reaktion darauf, dass die Vibrationsintensität innerhalb eines ersten voreingestellten Vibrationsintensitätsbereichs liegt, die Analysezeit entsprechend der Spannungsstörungskurve als voreingestellte Analysezeit bestimmt wird, und die Anzahl der Verarbeitungsschichten für die Kurven-Wavelet-Paket-Zerlegung entsprechend der Spannungsstörungskurve als eine erste voreingestellte Schichtanzahl bestimmt wird; und als Reaktion darauf, dass die Vibrationsintensität innerhalb eines zweiten voreingestellten Vibrationsintensitätsbereichs liegt, die Analysezeit entsprechend der Spannungsstörungskurve gemäß der Vibrationszeit der Spannungsstörungskurve bestimmt wird, und die Anzahl der Verarbeitungsschichten für die Kurven-Wavelet-Paket-Zerlegung entsprechend der Spannungsstörungskurve als eine zweite voreingestellte Schichtanzahl bestimmt wird.

11. System nach Anspruch 8, wobei der Wavelet-Zerlegungskoeffizienten-Bestimmungsabschnitt ferner konfiguriert ist, um den Wavelet-Zerlegungskoeffizienten jeder Schicht entsprechend der Spannungsstörungskurve des Knotens entsprechend der Analyseaufgabe zu bestimmen, durch:

$$d_{hn} = \sum_{l=0}^{2^n-1} h_{n-2l} d_{h(2l)} + \sum_{l=0}^{2^n-1} g_{n-2l} d_{g(2l)} \,,$$

$$d_{gn} = \sum_{l=0}^{2^n-1} h_{n-(2l+1)} d_{h(2l)} + \sum_{l=0}^{2^n-1} g_{n-(2l+1)} d_{g(2l+1)} \,,$$

wobei $d_{hn}$ ein Hochfrequenz-Wavelet-Zerlegungskoeffizient einer $n^{ten}$ Schicht ist; $d_{gn}$ ein Niederfrequenz-Wavelet-Zerlegungskoeffizient der $n^{ten}$ Schicht ist; $l$ eine Anzahl von Wavelet-Teilräumen ist, die zu der $n^{ten}$ Schicht zerlegt sind; $h_{n-2l}$, $h_{n-(2l+1)}$, $g_{n-2l}$ und $g_{n-(2l+1)}$ allgemeine Funktionen von Realkoeffizientenfiltern für die Wavelet-Analyse sind; $d_{h(2l)}$ ein Hochfrequenz-Wavelet-Zerlegungs-Teilraumkoeffizient ist, der zu der $n^{ten}$ Schicht zerlegt wird, wobei angegeben wird, dass ein Hochfrequenz-Wavelet-Koeffizient der $n^{ten}$ Schicht eine Kombination von $2l$ Teilraum-Wavelet-Hochfrequenzkoeffizienten enthält; $d_{g(2l)}$ ein Niederfrequenz-Wavelet-Zerlegungs-Teilraumkoeffizient ist, der zu der $n^{ten}$ Schicht zerlegt wird, wobei angegeben wird, dass der Hochfrequenz-Wavelet-Koeffizient der $n^{ten}$ Schicht eine Kombination von $2l$ Teilraum-Wavelet-Niederfrequenzkoeffizienten enthält; und $d_{g(2l+1)}$ ein Nieder-frequenz-Wavelet-Zerlegungs-Teilraumkoeffizient ist, der zu der $n^{ten}$ Schicht zerlegt wird, wobei angegeben wird, dass eine Kombination von $2l+1$ Teilraum-Wavelet-Niederfrequenzkoeffizienten weiterhin in dem Niederfrequenz-Wavelet-Zerlegungskoeffizienten $d_{gn}$ der $n^{ten}$ Schicht enthalten ist.

12. System nach Anspruch 8, wobei der Bestimmungsabschnitt für einen charakteristischen Wert ferner konfiguriert ist, um gemäß dem Wavelet-Zerlegungskoeffizienten jeder Schicht entsprechend der Spannungsstörungskurve des Knotens entsprechend der Analyseaufgabe, den charakteristischen Wert jeder Schicht zu bestimmen, durch:

$$E_{ntotal} = E_{hn} + E_{gn} \,,$$

$$E_{hn} = \sqrt{2} \sum_{k=0}^{n} d_{hn} \mu_{2n} (2t-k) f_{hn}(t) \,,$$

$$E_{gn} = \sqrt{2} \sum_{k=0}^{n} d_{gn} \mu_{2n} (2t-k) f_{gn}(t) \,,$$

$$\mu_{2n}(2t-k) = \frac{2\xi^2}{f_p^3\sqrt{\pi}} e^{\left(-\frac{\xi^2}{f_p^2}\right)} e^{-j2\pi\xi(2t-k)}$$

,

wobei $E_{ntotal}$ ein charakteristischer Wert einer $n^{ten}$ Schicht ist; $E_{hn}$ und $E_{gn}$ charakteristische Werte von Hochfrequenz- bzw. Niederfrequenz-Wavelets der $n^{ten}$ Schicht sind; $d_{hn}$ ein Hochfrequenz-Wavelet-Zerlegungskoeffizient der $n^{ten}$ Schicht ist; $d_{gn}$ ein Niederfrequenz-Wavelet-Zerlegungskoeffizient der $n^{ten}$ Schicht ist; $f(t)$ eine Funktion ist, die durch zu analysierende Spannungsstörungskurvendaten ausgebildet wird, und $t$ die Analysezeit ist; $f_{hn}(t)$ eine Hochfrequenz-Zerlegungsfunktion der $n^{ten}$ Schicht zu einem Zeitpunkt $t$ ist und $f_{gn}(t)$ eine Niederfrequenz-Zerlegungsfunktion der $n^{ten}$ Schicht zu dem Zeitpunkt $t$ ist; $\mu_{2n}(2t-k)$ eine Wavelet-Paket-Generierungsfunktion ist, die durch eine orthogonale Skalierungsfunktion bestimmt wird, $t$ die Analysezeit ist, $k$ eine Anzahl von Wavelet-Teilräumen ist und $f_p$ eine Schwankungsfrequenz der Störungskurve ist; $\xi$ ein Abbruchfehlerkoeffizient der Wavelet-Zerlegung ist; und $j$ einen imaginären Teil darstellt.

13. System nach Anspruch 8, ferner umfassend einen Bestimmungsabschnitt für eine charakteristische Schwelle, der konfiguriert ist zum:

    Bestimmen der charakteristischen Schwelle jeder Schicht durch:

$$Th_n = \| \mu_n \|^2 + \tau^T \times J_4^{-1}$$ ,

    wobei $Th_n$ eine charakteristische Schwelle entsprechend einer $n^{ten}$ Schicht ist; $\mu_n$ ein Bifurkationssteuerparameter entsprechend der $n^{ten}$ Schicht ist; $\tau^T$ eine Transponierte eines Lagrange-Multiplikators $\tau$ ist; und $J_4^{-1}$ eine inverse Matrix einer charakteristischen Wertmatrix $J_4$ von Differential-Algebraischen Gleichungen, DAE, für ein integriertes Leistungssystem mit hohem Anteil erneuerbarer Energien ist.

14. System nach Anspruch 8, wobei der Stabilitätsanalyseabschnitt ferner konfiguriert ist zum:
für einen charakteristischen Wert einer Schicht entsprechend der Spannungsstörungskurve des Knotens entsprechend der Analyseaufgabe, Bestimmen des Spannungsstabilitätsanalyseergebnisses des Knotens entsprechend der Analyseaufgabe als einen Spannungsinstabilitätsknoten, als Reaktion darauf, dass der charakteristische Wert der Schicht größer als oder gleich einer charakteristischen Schwelle einer aktuellen Schicht ist; und Bestimmen des Spannungsstabilitätsanalyseergebnisses des Knotens entsprechend Analyseaufgabe als einen Spannungsstabilitätsknoten, als Reaktion darauf, dass der charakteristische Wert der Schicht niedriger als die charakteristische Schwelle der aktuellen Schicht ist.

15. Computerlesbares Speichermedium, das ein Computerprogramm darauf gespeichert aufweist, das beim Ausführen durch einen Prozessor den Prozessor aktiviert, das Verfahren nach einem der Ansprüche 1 bis 7 zu implementieren.

16. Elektronische Vorrichtung, umfassend:

    das computerlesbare Speichermedium nach Anspruch 15; und
    einen oder mehrere Prozessoren, die konfiguriert sind, um ein Programm auf dem computerlesbaren Speichermedium auszuführen.

17. Computerprogrammprodukt, umfassend ein Computerprogramm oder Anweisungen, die, wenn sie auf einer elektronischen Vorrichtung ablaufen, die elektronische Vorrichtung aktivieren, um das Verfahren nach einem der Ansprüche 1 bis 7 zu implementieren.

## Revendications

1. Procédé permettant d'analyser une stabilité de tension en fonction d'une caractéristique d'oscillations multiples d'une courbe de perturbation de tension, **caractérisé en ce qu'il** comprend :

l'acquisition (S101), par un serveur principal, d'une courbe de perturbation de tension d'au moins un nœud, et pour chaque courbe de perturbation de tension, l'analyse de la courbe de perturbation de tension en fonction d'une caractéristique d'oscillations multiples, pour déterminer un temps d'analyse et un nombre de couches de traitement pour une décomposition en paquets d'ondelettes de courbe correspondant à la courbe de perturbation de tension ;

l'établissement (S102), par le serveur principal, d'une tâche d'analyse pour chaque nœud, et la distribution de la tâche d'analyse à au moins un sous-serveur selon une stratégie de distribution prédéfinie ;

la mise en œuvre (S103), pour l'un parmi l'au moins un sous-serveur, en fonction d'un temps d'analyse et d'un nombre de couches de traitement pour décomposition en paquets d'ondelettes de courbe correspondant à une courbe de perturbation de tension d'un nœud correspondant à une tâche d'analyse qui est reçue, d'une analyse de paquet d'ondelettes sur la courbe de perturbation de tension, pour acquérir un coefficient de décomposition en ondelettes de chaque couche correspondant à la courbe de perturbation de tension du nœud correspondant à la tâche d'analyse ;

la détermination (S104), pour celui précité parmi l'au moins un sous-serveur, selon le coefficient de décomposition en ondelettes de chaque couche correspondant à la courbe de perturbation de tension du nœud correspondant à la tâche d'analyse, d'une valeur de caractéristique de chaque couche ; et

la détermination (S105), pour celui précité parmi l'au moins un sous-serveur, selon la valeur de caractéristique et un seuil de caractéristique de chaque couche correspondant à la courbe de perturbation de tension du nœud correspondant à la tâche d'analyse, d'un résultat d'analyse de stabilité de tension du nœud correspondant à la tâche d'analyse.

2. Procédé selon la revendication 1, dans lequel un type du nœud comprend au moins l'un parmi : un nœud de charge, un nœud de station à courant continu, CC, un nœud de capacité, un nœud de générateur, un nœud de modulateur de phase ou un nœud de station d'énergie renouvelable.

3. Procédé selon la revendication 1, dans lequel l'analyse de la courbe de perturbation de tension en fonction de la caractéristique d'oscillations multiples, pour déterminer le temps d'analyse et le nombre de couches de traitement pour décomposition en paquets d'ondelettes de courbe correspondant à la courbe de perturbation de tension comprend :

pour chaque courbe de perturbation de tension, la mise en œuvre d'une analyse de paquet d'ondelettes sur la caractéristique d'oscillations multiples de la courbe de perturbation de tension, pour acquérir une intensité de vibration de la courbe de perturbation de tension ; et

la détermination, selon l'intensité de vibration, du temps d'analyse et du nombre de couches de traitement pour décomposition en paquets d'ondelettes de courbe pour la courbe de perturbation de tension ;

dans lequel, pour la courbe de perturbation de tension, en réponse au fait que l'intensité de vibration est au sein d'une première plage prédéfinie d'intensité de vibration, le temps d'analyse correspondant à la courbe de perturbation de tension est déterminé en tant que temps d'analyse prédéfini, et le nombre de couches de traitement pour décomposition en paquets d'ondelettes de courbe correspondant à la courbe de perturbation de tension est déterminé en tant que premier nombre prédéfini de couches ; en réponse au fait que l'intensité de vibration est au sein d'une seconde plage prédéfinie d'intensité de vibration, le temps d'analyse correspondant à la courbe de perturbation de tension est déterminé selon un temps de vibration de la courbe de perturbation de tension, et le nombre de couches de traitement pour décomposition en paquets d'ondelettes de courbe correspondant à la courbe de perturbation de tension est déterminé en tant que second nombre prédéfini de couches.

4. Procédé selon la revendication 1, dans lequel le coefficient de décomposition en ondelettes de chaque couche correspondant à la courbe de perturbation de tension du nœud correspondant à la tâche d'analyse est déterminé par :

$$d_{hn} = \sum_{l=0}^{2^n-1} h_{n-2l} d_{h(2l)} + \sum_{l=0}^{2^n-1} g_{n-2l} d_{g(2l)},$$

$$d_{gn} = \sum_{l=0}^{2^n-1} h_{n-(2l+1)} d_{h(2l)} + \sum_{l=0}^{2^n-1} g_{n-(2l+1)} d_{g(2l+1)} \quad ,$$

dans lequel $d_{hn}$ est un coefficient de décomposition en ondelettes haute fréquence d'une $n^{ième}$ couche ; $d_{gn}$ est un coefficient de décomposition en ondelettes basse fréquence de la $n^{ième}$ couche ; $l$ est un nombre de sous-espaces d'ondelettes décomposés à la $n^{ième}$ couche ; $h_{n-2l}$, $h_{n-(2l+1)}$, $g_{n-2l}$ et $g_{n-(2l+1)}$ sont des fonctions générales de filtres de coefficients réels pour analyse d'ondelettes ; $d_{h(2l)}$ est un coefficient de sous-espace de décomposition d'ondelette haute fréquence décomposé à la $n^{ième}$ couche, indiquant qu'un coefficient d'ondelette haute fréquence de la $n^{ième}$ couche contient une combinaison de $2l$ coefficients haute fréquence d'ondelettes de sous-espace ; $d_{g(2l)}$ est un coefficient de sous-espace de décomposition d'ondelette basse fréquence décomposé à la $n^{ième}$ couche, indiquant que le coefficient d'ondelette haute fréquence de la $n^{ième}$ couche contient une combinaison de $2l$ coefficients basse fréquence d'ondelettes de sous-espace ; et $d_{g(2l+1)}$ est un coefficient de sous-espace de décomposition d'ondelette basse fréquence décomposé à la $n^{ième}$ couche, indiquant qu'une combinaison de $2l+1$ coefficients basse fréquence d'ondelettes de sous-espace est contenue en outre dans le coefficient de décomposition en ondelettes basse fréquence $d_{gn}$ de la $n^{ième}$ couche.

**5.** Procédé selon la revendication 1, dans lequel la valeur de caractéristique de chaque couche est déterminée, selon le coefficient de décomposition en ondelettes de chaque couche correspondant à la courbe de perturbation de tension du nœud correspondant à la tâche d'analyse, par :

$$E_{ntotal} = E_{hn} + E_{gn} ,$$

$$E_{hn} = \sqrt{2} \sum_{k=0}^{n} d_{hn} \mu_{2n}(2t-k) f_{hn}(t) \quad ,$$

$$E_{gn} = \sqrt{2} \sum_{k=0}^{n} d_{gn} \mu_{2n}(2t-k) f_{gn}(t) \quad ,$$

$$\mu_{2n}(2t-k) = \frac{2\xi^2}{f_p^3 \sqrt{\pi}} e^{(-\frac{\xi^2}{f_p^2})} e^{-j2\pi\xi(2t-k)} \quad ,$$

dans lequel $E_{ntotal}$ est une valeur de caractéristique d'une $n^{ième}$ couche ; $E_{hn}$ et $E_{gn}$ sont des valeurs de caractéristique d'ondelettes haute fréquence et basse fréquence de la $n^{ième}$ couche respectivement ; $d_{hn}$ est un coefficient de décomposition en ondelettes haute fréquence de la $n^{ième}$ couche ; $d_{gn}$ est un coefficient de décomposition en ondelettes basse fréquence de la $n^{ième}$ couche ; $f(t)$ est une fonction formée par des données de courbe de perturbation de tension à analyser, et $t$ est le temps d'analyse ; $f_{hn}(t)$ est une fonction de décomposition haute fréquence de la $n^{ième}$ couche à un moment $t$, et $f_{gn}(t)$ est une fonction de décomposition basse fréquence de la $n^{ième}$ couche au moment $t$ ; $\mu_{2n}(2t-k)$ est une fonction de génération de paquet d'ondelettes déterminée par une fonction de mise à l'échelle orthogonale, t est le temps d'analyse, k est un nombre de sous-espaces d'ondelettes, et $f_p$ est une fréquence de fluctuation de la courbe de perturbation ; $\xi$ est un coefficient d'erreur de troncature de décomposition en ondelettes ; et $j$ représente une partie imaginaire.

**6.** Procédé selon la revendication 1, comprenant en outre :

la détermination du seuil de caractéristique de chaque couche par :

$$Th_n = \| \mu_n \|^2 + \tau^T \times J_4^{-1},$$

dans lequel $Th_n$ est un seuil de caractéristique correspondant à une n$^{\text{ième}}$ couche ; $\mu_n$ est un paramètre de commande de bifurcation correspondant à la n$^{\text{ième}}$ couche ; $\tau^T$ est une transposition d'un multiplicateur de Lagrange $\tau$ ; et $J_4^{-1}$ est une matrice inverse d'une matrice de valeur de caractéristique $J_4$ d'équations algébriques différentielles, DAE, pour un système de puissance intégré à haute proportion d'énergie renouvelable.

**7.** Procédé selon la revendication 1, dans lequel la détermination, selon la valeur de caractéristique et le seuil de caractéristique de chaque couche correspondant à la courbe de perturbation de tension du nœud correspondant à la tâche d'analyse, du résultat d'analyse de stabilité de tension du nœud correspondant à la tâche d'analyse, comprend :
pour une valeur de caractéristique d'une couche correspondant à la courbe de perturbation de tension du nœud correspondant à la tâche d'analyse, la détermination du résultat d'analyse de stabilité de tension du nœud correspondant à la tâche d'analyse en tant que nœud d'instabilité de tension, en réponse au fait que la valeur de caractéristique de la couche est supérieure ou égale à un seuil de caractéristique d'une couche actuelle ; et la détermination du résultat d'analyse de stabilité de tension du nœud correspondant à la tâche d'analyse en tant que nœud de stabilité de tension, en réponse au fait que la valeur de caractéristique de la couche est inférieure au seuil de caractéristique de la couche actuelle.

**8.** Système permettant d'analyser une stabilité de tension en fonction d'une caractéristique d'oscillations multiples d'une courbe de perturbation de tension, **caractérisé en ce qu'il** comprend :

une section d'analyse de courbe de perturbation de tension (201), configurée pour acquérir, par le biais d'un serveur principal, une courbe de perturbation de tension d'au moins un nœud ; et pour chaque courbe de perturbation de tension, analyser, par le biais du serveur principal, la courbe de perturbation de tension en fonction d'une caractéristique d'oscillations multiples, pour déterminer un temps d'analyse et un nombre de couches de traitement pour décomposition en paquets d'ondelettes de courbe correspondant à la courbe de perturbation de tension ;
une section de distribution de tâche (202), configurée pour établir, par le biais du serveur principal, une tâche d'analyse pour chaque nœud, et distribuer, par le biais du serveur principal, la tâche d'analyse à au moins un sous-serveur selon une stratégie de distribution prédéfinie ;
une section de détermination de coefficient de décomposition en ondelettes (203), configurée pour mettre en œuvre, pour l'un parmi l'au moins un sous-serveur, en fonction d'un temps d'analyse et d'un nombre de couches de traitement pour décomposition en paquets d'ondelettes de courbe correspondant à une courbe de perturbation de tension d'un nœud correspondant à une tâche d'analyse qui est reçue, une analyse de paquet d'ondelettes sur la courbe de perturbation de tension, pour acquérir un coefficient de décomposition en ondelettes de chaque couche correspondant à la courbe de perturbation de tension du nœud correspondant à la tâche d'analyse ;
une section de détermination de valeur de caractéristique (204), configurée pour déterminer, pour celui précité parmi l'au moins un sous-serveur, selon le coefficient de décomposition en ondelettes de chaque couche correspondant à la courbe de perturbation de tension du nœud correspondant à la tâche d'analyse, une valeur de caractéristique de chaque couche ; et
une section d'analyse de stabilité (205), configurée pour déterminer, pour celui précité parmi l'au moins un sous-serveur, selon la valeur de caractéristique et un seuil de caractéristique de chaque couche correspondant à la courbe de perturbation de tension du nœud correspondant à la tâche d'analyse, un résultat d'analyse de stabilité de tension du nœud correspondant à la tâche d'analyse.

**9.** Système selon la revendication 8, dans lequel un type du nœud comprend au moins l'un parmi : un nœud de charge, un nœud de station à courant continu, CC, un nœud de capacité, un nœud de générateur, un nœud de modulateur de phase ou un nœud de station d'énergie renouvelable.

**10.** Système selon la revendication 8, dans lequel la section d'analyse de courbe de perturbation de tension est configurée en outre pour :

pour chaque courbe de perturbation de tension, mettre en œuvre une analyse de paquet d'ondelettes sur la caractéristique d'oscillations multiples de la courbe de perturbation de tension, pour acquérir une intensité de vibration de la courbe de perturbation de tension ; et

déterminer, selon l'intensité de vibration, le temps d'analyse et le nombre de couches de traitement pour décomposition en paquets d'ondelettes de courbe pour la courbe de perturbation de tension ;

dans lequel, pour la courbe de perturbation de tension, en réponse au fait que l'intensité de vibration est au sein d'une première plage prédéfinie d'intensité de vibration, le temps d'analyse correspondant à la courbe de perturbation de tension est déterminé en tant que temps d'analyse prédéfini, et le nombre de couches de traitement pour décomposition en paquets d'ondelettes de courbe correspondant à la courbe de perturbation de tension est déterminé en tant que premier nombre prédéfini de couches ; et en réponse au fait que l'intensité de vibration est au sein d'une seconde plage prédéfinie d'intensité de vibration, le temps d'analyse correspondant à la courbe de perturbation de tension est déterminé selon un temps de vibration de la courbe de perturbation de tension, et le nombre de couches de traitement pour décomposition en paquets d'ondelettes de courbe correspondant à la courbe de perturbation de tension est déterminé en tant que second nombre prédéfini de couches.

11. Système selon la revendication 8, dans lequel la section de détermination de coefficient de décomposition en ondelettes est configurée en outre pour déterminer le coefficient de décomposition en ondelettes de chaque couche correspondant à la courbe de perturbation de tension du nœud correspondant à la tâche d'analyse par :

$$d_{hn} = \sum_{l=0}^{2^n-1} h_{n-2l} d_{h(2l)} + \sum_{l=0}^{2^n-1} g_{n-2l} d_{g(2l)},$$

$$d_{gn} = \sum_{l=0}^{2^n-1} h_{n-(2l+1)} d_{h(2l)} + \sum_{l=0}^{2^n-1} g_{n-(2l+1)} d_{g(2l+1)},$$

dans lequel $d_{hn}$ est un coefficient de décomposition en ondelettes haute fréquence d'une $n^{ième}$ couche ; $d_{gn}$ est un coefficient de décomposition en ondelettes basse fréquence de la $n^{ième}$ couche ; $l$ est un nombre de sous-espaces d'ondelettes décomposés à la $n^{ième}$ couche ; $h_{n-2l}$, $h_{n-(2l+1)}$, $g_{n-2l}$ et $g_{n-(2l+1)}$ sont des fonctions générales de filtres de coefficients réels pour analyse d'ondelettes ; $d_{h(2l)}$ est un coefficient de sous-espace de décomposition d'ondelette haute fréquence décomposé à la $n^{ième}$ couche, indiquant qu'un coefficient d'ondelette haute fréquence de la $n^{ième}$ couche contient une combinaison de $2l$ coefficients haute fréquence d'ondelettes de sous-espace ; $d_{g(2l)}$ est un coefficient de sous-espace de décomposition d'ondelette basse fréquence décomposé à la $n^{ième}$ couche, indiquant que le coefficient d'ondelette haute fréquence de la $n^{ième}$ couche contient une combinaison de $2l$ coefficients basse fréquence d'ondelettes de sous-espace ; et $d_{g(2l+1)}$ est un coefficient de sous-espace de décomposition d'ondelette basse fréquence décomposé à la $n^{ième}$ couche, indiquant qu'une combinaison de $2l+1$ coefficients basse fréquence d'ondelettes de sous-espace est contenue en outre dans le coefficient de décomposition en ondelettes basse fréquence $d_{gn}$ de la $n^{ième}$ couche.

12. Système selon la revendication 8, dans lequel la section de détermination de valeur de caractéristique est configurée en outre pour déterminer, selon le coefficient de décomposition en ondelettes de chaque couche correspondant à la courbe de perturbation de tension du nœud correspondant à la tâche d'analyse, la valeur de caractéristique de chaque couche par :

$$E_{ntotal} = E_{hn} + E_{gn},$$

$$E_{hn} = \sqrt{2} \sum_{k=0}^{n} d_{hn} \mu_{2n} (2t-k) f_{hn}(t),$$

$$E_{gn} = \sqrt{2} \sum_{k=0}^{n} d_{gn} \mu_{2n} (2t-k) f_{gn}(t),$$

$$\mu_{2n}(2t-k) = \frac{2\xi^2}{f_p^3\sqrt{\pi}} e^{(-\frac{\xi^2}{f_p^2})} e^{-j2\pi\xi(2t-k)}$$

,

dans lequel $E_{ntotal}$ est une valeur de caractéristique d'une n$^{\text{ième}}$ couche ; $E_{hn}$ et $E_{gn}$ sont des valeurs de caractéristique d'ondelettes haute fréquence et basse fréquence de la n$^{\text{ième}}$ couche respectivement ; $d_{hn}$ est un coefficient de décomposition en ondelettes haute fréquence de la n$^{\text{ième}}$ couche ; $d_{gn}$ est un coefficient de décomposition en ondelettes basse fréquence de la n$^{\text{ième}}$ couche ; f(t) est une fonction formée par des données de courbe de perturbation de tension à analyser, et $t$ est le temps d'analyse ; $f_{hn}(t)$ est une fonction de décomposition haute fréquence de la n$^{\text{ième}}$ couche à un moment $t$, et $f_{gn}(t)$ est une fonction de décomposition basse fréquence de la n$^{\text{ième}}$ couche au moment $t$ ; $\mu_{2n}(2t\text{-}k)$ est une fonction de génération de paquet d'ondelettes déterminée par une fonction de mise à l'échelle orthogonale, $t$ est le temps d'analyse, k est un nombre de sous-espaces d'ondelettes, et $f_p$ est une fréquence de fluctuation de la courbe de perturbation ; $\xi$ est un coefficient d'erreur de troncature de décomposition en ondelettes ; et $j$ représente une partie imaginaire.

**13.** Système selon la revendication 8, comprenant en outre une section de détermination de seuil de caractéristique, configurée pour :

déterminer le seuil de caractéristique de chaque couche par :

$$Th_n = \| \mu_n \|^2 + \tau^T \times J_4^{-1}$$

,

dans lequel $Th_n$ est un seuil de caractéristique correspondant à une n$^{\text{ième}}$ couche ; $\mu_n$ est un paramètre de commande de bifurcation correspondant à la n$^{\text{ième}}$ couche ; $\tau^T$ est une transposition d'un multiplicateur de Lagrange $\tau$ ; et $J_4^{-1}$ est une matrice inverse d'une matrice de valeur de caractéristique $J_4$ d'équations algébriques différentielles, DAE, pour un système de puissance intégré à haute proportion d'énergie renouvelable.

**14.** Système selon la revendication 8, dans lequel la section d'analyse de stabilité est configurée en outre pour :
pour une valeur de caractéristique d'une couche correspondant à la courbe de perturbation de tension du nœud correspondant à la tâche d'analyse, déterminer le résultat d'analyse de stabilité de tension du nœud correspondant à la tâche d'analyse en tant que nœud d'instabilité de tension, en réponse au fait que la valeur de caractéristique de la couche est supérieure ou égale à un seuil de caractéristique d'une couche actuelle ; et déterminer le résultat d'analyse de stabilité de tension du nœud correspondant à la tâche d'analyse en tant que nœud de stabilité de tension, en réponse au fait que la valeur de caractéristique de la couche est inférieure au seuil de caractéristique de la couche actuelle.

**15.** Support de stockage lisible par ordinateur sur lequel est stocké un programme informatique qui, lorsqu'il est exécuté par un processeur, permet au processeur d'implémenter des opérations du procédé selon l'une quelconque des revendications 1 à 7.

**16.** Dispositif électronique, comprenant :

le support de stockage lisible par ordinateur selon la revendication 15 ; et
un ou plusieurs processeurs configurés pour exécuter un programme dans le support de stockage lisible par ordinateur.

**17.** Produit programme d'ordinateur, comprenant un programme d'ordinateur ou des instructions qui, lors d'une exécution sur un dispositif électronique, permet au dispositif électronique d'implémenter le procédé selon l'une quelconque des revendications 1 à 7.

100

A main server acquires a voltage disturbance curve of at least one node; and for each voltage disturbance curve, analyzes the voltage disturbance curve based on a multi-swing characteristic, to determine analysis time and a number of processing layers for curve wavelet package decomposition corresponding to the voltage disturbance curve

S101

The main server establishes an analysis task for each node, and distributes the analysis task to at least one sub-server according to a preset distribution strategy

S102

For one of the at least one sub-server, based on analysis time and a number of processing layers for curve wavelet package decomposition corresponding to a voltage disturbance curve of a node corresponding to an analysis task that is received, a wavelet package analysis is performed on the voltage disturbance curve, to acquire a wavelet decomposition coefficient of each layer corresponding to the voltage disturbance curve of the node corresponding to the analysis task

S103

For the one of the at least one sub-server, according to the wavelet decomposition coefficient of each layer corresponding to the voltage disturbance curve of the node corresponding to the analysis task, a characteristic value of each layer is determined

S104

For the one of the at least one sub-server, according to the characteristic value and a characteristic threshold of each layer corresponding to the voltage disturbance curve of the node corresponding to the analysis task, a voltage stability analysis result of the node corresponding to the analysis task is determined

S105

**FIG. 1**

200

```
┌─────────────────────────────────────────────────────┐
│  ┌───────────────────────────────────────────────┐  │
│  │   Voltage disturbance curve analysis section 201 │  │
│  └───────────────────────────────────────────────┘  │
│                                                       │
│  ┌───────────────────────────────────────────────┐  │
│  │        Task distribution section 202            │  │
│  └───────────────────────────────────────────────┘  │
│                                                       │
│  ┌───────────────────────────────────────────────┐  │
│  │  Wavelet decomposition coefficient determination │  │
│  │                 section 203                     │  │
│  └───────────────────────────────────────────────┘  │
│                                                       │
│  ┌───────────────────────────────────────────────┐  │
│  │   Characteristic value determination section 204 │  │
│  └───────────────────────────────────────────────┘  │
│                                                       │
│  ┌───────────────────────────────────────────────┐  │
│  │        Stability analysis section 205           │  │
│  └───────────────────────────────────────────────┘  │
└─────────────────────────────────────────────────────┘
```

**FIG. 2**

**REFERENCES CITED IN THE DESCRIPTION**

**Patent documents cited in the description**

- CN 113949065 A

- CN 113949069 A